(19) Europäisches Patentamt
European Patent Office
Office européen des brevets

(11) EP 0 776 045 B1

(12) EUROPEAN PATENT SPECIFICATION

(45) Date of publication and mention of the grant of the patent:
**24.03.2004 Bulletin 2004/13**

(51) Int Cl.7: **H01L 27/115**, H01L 29/788, H01L 21/8247, H01L 29/51

(21) Application number: **96114019.1**

(22) Date of filing: **02.09.1996**

(54) **Semiconductor memory device and method for fabricating the same**

Halbleiter-Speicherbauteil und Verfahren zu seiner Herstellung

Dispositif de mémoire à semi-conducteur et procédé de fabrication

(84) Designated Contracting States:
**DE FR GB**

(30) Priority: **23.11.1995 KR 9543304**

(43) Date of publication of application:
**28.05.1997 Bulletin 1997/22**

(73) Proprietor: **LG Semicon Co., Ltd.**
**Cheongju-si, Chungcheongbuk-do (KR)**

(72) Inventor: **Park, Keun Hyung**
**Cheongju-si, Chungcheongbuk-do (KR)**

(74) Representative:
**TER MEER STEINMEISTER & PARTNER GbR**
**Patentanwälte,**
**Mauerkircherstrasse 45**
**81679 München (DE)**

(56) References cited:
**DE-A- 4 422 791**
**US-A- 4 888 630**
**US-A- 5 130 769**
**US-A- 5 329 487**

- **PATENT ABSTRACTS OF JAPAN vol. 018, no. 684 (E-1650), 22 December 1994 & JP 06 275840 A (ROHM CO LTD), 30 September 1994,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

### Background of the Invention

The present invention relates to a semiconductor memory, and more particularly, to a semiconductor memory device and its fabrication for enhancing packing density but reducing power consumption.

Recently, a flash memory, a nonvolatile semiconductor memory, has been being paid a lot of attention in the semiconductor memory markets. This is because the flash memory is expected to replace a hard disk drive (HDD), an external storage currently the most widely used in computer systems. For the cache memory and main storage of a computer system, an SRAM or DRAM electrically enabling reading/writing is currently used. However, they are volatile and undesirably lose stored data when power is off. For this reason, the computer system has an additional external storage consisting of a nonvolatile memory capable of continuously storing data even when power is off.

Presently, for the external storage, disk such as HDD or magnetic memory such as magnetic tape are mainly used. Magnetic memories are heavy, slow in data reading speed, have a large power consumption, are subject to external impacts, and difficult to miniaturize. However, prior to the flash memory, they are solely capable of enabling electrical reading/writing and much cheaper than EEPROM, a nonvolatile memory.

With the flash memory capable of electrical reading/writing and much cheaper than the conventional EEPROM, and with gradually widely distributed portable computers requiring miniaturization, lightness, low power consumption, and high impact-resistance, there has been increasing a trend to replace HDD with flash memory worldwide.

System makers are currently using PCMCIA flash memory cards for auxiliary HDD memory while using the conventional HDD for personal computer systems because HDD and flash memory have a large difference in cost.

However, if 64M flash memory starts to be produced in mass after 1997 as soon as possible and therefore the cost difference between the flash memory and HDD is reduced below three times, it is expected that PCMCIA flash memory card instead of HDD will be used for the main external storage of portable computers.

Besides, the flash memory will be used as storage in a variety of fields such as communication equipment of telephone, pager, facsimile, LAN, households of TV, VCR, game machine, camera, audio player, car components, military electronic equipment, and medical instruments.

An EEPROM of the conventional memory device will be explained with reference to the attached drawings.

Fig. 1 shows a circuit configuration of a conventional EEPROM, especially, a unit cell of INTEL's ETOX flash EEPROM which is one of the most typical flash EEPROMs.

A general EEPROM cell is made in the floating-gate avalanche-injection metal oxide semiconductor (FAMOS) having a stacked gate MOSFET. The respective cells' control gate C.G is connected to a single wordline W/L, their drain D to a single bitline B/L. Their source S is connected to a single common source line C.S.

Bitline B/L is connected to one input port of a sense AMP SA. The sense AMP's other input port is coupled to a reference voltage Vref. The structure of the general EEPROM cell is shown in Fig. 2.

Referring to Fig. 2, floating gate F.G and control gate C.G are stacked sequentially on P-type silicon substrate 1. Source and drain S and D, that is, N-type impurity region, are formed on P-type silicon substrate 1 placed on both sides of floating gate F.G. Here, an insulating layer is formed between silicon substrate 1 and floating gate F.G and between the floating gate and control gate C.G. Between floating gate F.G and control gate C.G, the insulating layer is formed as thick as the gate insulating layer of a general transistor. Between floating gate F.G and silicon substrate 1, a tunnel oxide layer is formed below about 100Å. Now, the operation of the conventional flash EEPROM will be described below.

Fig. 3 shows a case in which data is written in the conventional EEPROM. Fig. 4 shows a case in which data is erased in the EEPROM.

First, in order to write data "1" in a cell, as shown in Fig. 3, a voltage of 7-8V is applied to bitline B/L corresponding to the cell, and a voltage pulse of 12-13V is applied to wordline W/L (control gate). Source S and substrate are grounded.

In this situation, avalanche breakdown is caused at the PN junction between drain D and the substrate, producing hot electrons.

Part of the hot electrons obtains an energy larger than the energy barrier (about 3.2eV) between the substrate and tunnel oxide layer, and enters floating gate F.G, via the tunnel oxide layer from the substrate, to be stored therein. This method is called channel hot electron injection.

Here, as the number of electrons stored in floating gate F.G increases, the cell's threshold voltage increases. Therefore, writing is performed so that generally the cell's threshold voltage becomes over 7V. Once the electrons are accumulated in floating gate F.G, the natural electron emission amount is so small as to be ignored and thus the amount of the accumulated electrons is maintained constantly for years, because the energy barrier between floating gate F.G and the insulating layer completely surrounding the floating gate is greater than 3eV. This state of cell indicates logic "1" in binary.

Erasing data written in a cell will be performed as follows.

As shown in Fig. 4, the substrate and control gate C.G are grounded, the drain is made to float, and a voltage pulse of 12-13V is applied to a common source line C.S. Due to Fowler-Nordheim tunnelling, electrons accumulated in floating gate F.G are induced to source S via a thin gate oxide layer. Here, as the emission amount of electrons accumulated in floating gate F.G increases, the cell's threshold voltage gradually decreases to a lower value. For this reason, erasure is performed so that the cell's threshold voltage becomes below 3V. This state indicates logic "0" in binary.

Reading data accumulated in a cell will be described below.

1-2V is applied to bitline B/L connected to cell's drain D, and the substrate and source S are grounded. A voltage pulse of 3-5V is applied to wordline W/L connected to cell's control gate C.G. Here, in case data "1" is stored in the cell, it is OFF so that the charges stored in bitline B/L are not emitted to maintain the previously applied voltage 1-2V.

In case data "0" is stored in the cell, it is ON so that the charges stored in bitline B/L are emitted to ground bitline B/L. Such a potential difference of bitline B/L is recognized by sense AMP connected to bitline B/L so that data accumulated in the cell is read out.

In the conventional ETOX flash EEPROM, random access is enabled in data reading, and a data reading time is relatively short. Despite those advantages, it has many drawbacks to solve. Among them are as follows.

First, when data stored in the cell, the control gate and substrate are grounded and a high voltage of 13V is applied to the source so that a voltage is not externally applied to the drain. Therefore, there is caused a large difference of voltage between the source and substrate. In the source junction, band-to-band tunneling and avalanche breakdown are caused. Accordingly, many pairs of electron-valance electron are produced at the source junction. Part of them are accelerated by the electric field at a deep depletion region formed at the source junction so that they become valance electrons of a high energy (so called hot hole) and are implanted to the tunnel oxide layer. Part of them are captured by the gate oxide layer. These captured valance electrons increase tunneling rate in erasing.

For this reason, the erasing threshold voltage of the cells in which valence electrons are captured in the tunnel oxide layer becomes sharply lower than that of usual cells in which valence electrons are not captured in the gate oxide layer.

As the case may be, their erasing threshold voltage may have a negative voltage. In this case, leakage current always flows through those cells, causing errors in data reading. This is called overerase problem.

Bad bits whose threshold voltage becomes too low after erasure due to valence electron capture in the gate oxide layer do not always remain as bad bits. Considerable number of the bad bits return to normal cells because valence electrons held by the tunnel oxide layer are lost by being recombined with electrons passing through the tunnel oxide layer in later erasure. In another case, as the cycle of program/erasure proceeds, some cells become bad while initially they were normal cells.

As explained above, it is never expected when and in which cell the capture of valence electrons in the gate oxide layer occurs. For this reason, devices which may cause this problem cannot be previously checked in a screening test performed after the fabrication process.

Meanwhile, in order to reduce such an overerase, as shown in Figs. 3 and 4, the conventional ETOX flash EEPROM is made so that the source junction is a deep graded junction to reduce hot holes in erasure. Even in this case, the hot holes cannot be prevented completely. In addition, the source junction is formed deep to increase the area of unit cell.

Secondly, in programming a cell, the wordlines of other unselected cells coupled to the bitline of the programmed cell are grounded. A voltage of about 7-8V is applied to the drain. Among the unselected cells, previously programmed cells have electrons stored in the floating gate so that the potential of the floating gate becomes about -2--3V.

Between the drain and floating gate of unselected but previously programmed cells, a large difference of voltage of about 9-10V is formed so that the electrons of the floating gate are emitted to the drain, or hot holes produced at the drain junction are implanted to the floating gate, according to Fowler-Nordheim tunnelling. This effect makes lost electrons stored in the floating gate.

Thirdly, the conventional ETOX flash EEPROM performs programming using the channel hot electron injection. In case programming is performed using the method, a high voltage of about 6-8V is applied to a bitline coupled to a cell selected for programming. About 100 μA of current flows through the bitline. This consumes a large amount of power in programming.

US 4.888.630 discloses a Heating-gate transistor with a non-linear integrated dielectric which has a ferroelectric material for the dielectric between the floating gate electrode and the control gate electrode.

JP 06-275 840 A is concerned with a non-volatile storage element that comprises a capacitor insulation film which is sandwiched between a floating gate and a control gate. This capacitor insulation film consists of an oxide film, a nitride film and a ferroelectric film which are successively laminated.

US 5,329,487 discloses a two transistor flash EPROM cell that includes a first floating gate transistor for programming the cell and a second merge transistor for reading the cell. The first transistor, a floating gate transistor, has a drain coupled to the write bitline, a gate coupled to the wordline, and a source coupled to the source line. The merged transistor effectively consists of a floating gate transistor in series with a NMOS enhancement transistor. The control gate of the merged transistor is formed so as to having one part above the floating gate and at least one another part above a channel region of the transistor.

US 5,130,769 is concerned with a non-volatile memory cell and discloses a transistor comprising a floating gate which has two portions. A first portion overlying the channel region and a second portion overlying a thin oxide tunnel area of the source region. The control gate overlies the floating gate and a remaining portion of the channel region.

DE 44 22 791 AI discloses a semiconductor device having a memory cell transistor consisting of a floating gate overlying a central portion of a channel region between source and drain regions, and a control gate overlying the floating gate and channel regions on both sides of the central portion thereof. Thus, an inversion region is formed when a voltage is applied to. the control gate in the side portions of the channel region.

## Summary of the Invention

It is an object of the present invention to provide a semiconductor memory device and its fabrication method for reducing power consumption, data loss and the size of cell for high packing density.

This object is achieved by the semiconductor memory device according to claim 1 and the method according to claim 23.

## Brief Description of the Attached Drawings

Fig. 1 shows a circuit configuration of a unit cell of a conventional EEPROM;
Fig. 2 is a sectional view of the unit cell of the conventional EEPROM;
Fig. 3 illustrates an operation in which data is written in the conventional EEPROM;
Fig. 4 illustrates an operation in which data is erased in the conventional EEPROM;
Figs. 5A and 5B are sectional views of a unit cell for explaining the operation principle of the present invention;
Fig. 6 illustrates a circuit configuration of the first embodiment of the semiconductor memory device of the present invention;
Fig. 7 is a layout of the first embodiment of the semiconductor memory device of the present invention;
Fig. 8 is a sectional view of the first embodiment of the semiconductor memory device of the present invention, cut along line A-A' of Fig. 7;
Fig. 9 is a sectional view of the first embodiment of the semiconductor memory device of the present invention, cut along line B-B' of Fig. 7;
Figs. 10A-10I are sectional views for the sequential process of the first embodiment of the semiconductor memory device of the present invention, cut along line A-A' of Fig. 7;
Figs. 11A-11I are sectional views for the sequential process of the first embodiment of the semiconductor memory device of the present invention, cut along line B-B' of Fig. 7;
Figs. 12A-12E are sectional views for a process modified from the first embodiment of the semiconductor memory device of the present invention;
Fig. 13 shows a circuit configuration of the second embodiment of the semiconductor memory device of the present invention;
Fig. 14 is a layout of the second embodiment of the semiconductor memory device of the present invention;
Fig. 15 is a sectional view of the second embodiment of the semiconductor memory device of the present invention, cut along line A-A' of Fig. 14;
Fig. 16 is a sectional view of the second embodiment of the semiconductor memory device of the present invention, cut along line B-B' of Fig. 14;
Figs. 17A-17I are sectional views for the sequential process of the second embodiment of the semiconductor memory device of the present invention, cut along line A-A' of Fig. 14;
Figs. 18A-18I are sectional views for the sequential process of the second embodiment of the semiconductor memory device of the present invention, cut along line B-B' of Fig. 14;
Fig. 19 shows a capacitor response circuit when data "0" is read in the semiconductor memory device; and
Fig. 20 shows a capacitor response circuit when data "1" is read in the semiconductor memory device.

Detailed Description of Preferred Embodiment

Referring to Figs. 5A and 5B, a unit memory cell of the semiconductor memory device of the present invention is constructed as a stacked gate-MOS capacitor, in which a floating gate F.G for charging/discharging charges and a control gate C.G for controlling charging/discharging and reading/writing are stacked, and an impurity region 14 used as a charge in/output stage is formed on a substrate 10 and at least on one side of floating gate F.G. In the drawing, the charge in/output stage is placed on both sides thereof.

In such a stacked gate-MOS capacitor structure in which floating gate F.G and control gate C.G are stacked and impurity region 14 is formed on both sides of floating gate F.G and on the substrate, however, the semiconductor substrate between impurity regions 14 is not used as a channel for transmitting charges. Instead, this structure is made so that in programming, similar to a general EEPROM, writing data "0" or "1" is performed by charging or discharging charges in the floating gate, and data reading is performed by an inversion layer which is formed or not on the substrate between impurity region 14 according to whether charges are accumulated or discharged from floating gate F.G and whether a pulse is applied to control gate C.G or not. In other words, the structure uses charging/discharging of a capacitor between control gate C.G and floating gate F.G, a capacitor between floating gate F.G and the inversion layer, and a parasite capacitor between control gate C.G and impurity region 14. As shown in Fig. 5A, when charges are stored in floating gate F.G, the inversion layer is not formed on the substrate (channel area) between impurity region 14. If not, charges are not accumulated in the substrate between impurity region 14.

As shown in Fig. 5B, when charges are not accumulated in floating gate F.G, the inversion layer is formed on the substrate between impurity region 14. If so, charges are stored in the substrate between impurity region 14 on which the inversion layer is formed. Hereinafter, there will be described the configuration of the semiconductor memory device of the present invention whose unit cell is formed with a stacked gate-MOS capacitor.

The first embodiment of the semiconductor memory device of the present invention is shown in Fig. 6. Referring to Fig. 6, this embodiment of the present invention comprises stacked gate-MOS capacitors C11-Cnm arranged in a matrix for programming data according to whether charges are accumulated or not in the floating gate, wordlines WL1-WLm for controlling the same row of the stacked gate-MOS capacitors at the same time, bitlines BL1-BLn for writing and reading data from the same column of the stacked gate-MOS capacitors, and sensing AMPs SA1-SAn for sensing and outputting data from bitlines BL1-BLn.

Here, the control gates of the same row of stacked gate-MOS capacitors are connected to a single wordline. The charge in/output stages, that is, the impurity regions, of the same column of stacked gate-MOS capacitors are connected to a single bitline. Sensing AMPs SA1-SAn each take corresponding bitlines as their input ports. A reference voltage is applied to the other input port of the respective sensing AMPs SA1-SAn. The structure of the first embodiment of the semiconductor memory device of the present invention will be explained below.

First of all, the layout of the first embodiment of the semiconductor of the present invention is shown in Fig. 7 so that a field insulating layer 11 is formed at a predetermined interval on a field area to make a plurality of active regions on the substrate in one direction, and a plurality of wordlines 12 are formed at a predetermined interval on the semiconductor substrate on which field insulating layer 11 is formed, being perpendicular to the active regions.

With the semiconductor substrate placed between field insulating layer 11 as the active regions, a plurality of floating gates 13 are formed between wordlines 12 and the active regions. High-concentration N-type impurity regions 14, that is, charge in/output stages, are formed on the active regions placed between wordlines 12. A plurality of bitlines 15 are formed between field insulating layers 11, being perpendicular to wordlines 12. Here, high-concentration N-type impurity regions 14 perpendicular to wordlines 12 are connected to a single bit line.

Now, the sectional structure of the first embodiment of the semiconductor memory device of the present invention will be described below. Referring to Fig. 8, its section in the direction of wordlines 12 is constructed so that field insulating layer (oxide layer) 11 is formed dn P-type semiconductor substrate 10 at a predetermined interval, to thereby make a plurality of active regions. Through this procedure, the field areas and active regions are defined.

A tunnelling dielectric layer 16 is formed on P-type semiconductor substrate 10 of the active regions. A plurality of floating gates 13 are formed on tunnelling dielectric layer 16. Here, floating gates 13 are arranged at a predetermined interval in the matrix.

A ferroelectric layer 17 is formed on the overall surface of the substrate including floating gate 13. Wordlines 12 are formed on ferroelectric layer 17. An interlevel insulating layer 18 is formed on the overall surface of the substrate including wordlines 12. Bitlines 15 are formed on interlevel insulating layer 18 placed above the active regions, being perpendicular to wordlines 12. Here, one wordline 12 is formed to commonly have floating gates 13 corresponding to rows perpendicular to the active regions. For tunnelling oxide layer 16 and ferroelectric layer 17, PZT (lead zirconate titanate) is preferably used.

Meanwhile, referring to Fig. 9, the sectional structure of the semiconductor memory device of the present invention is constructed so that tunnelling dielectric layer 16 is formed on P-type semiconductor substrate 10, and a plurality of floating gates 13 are formed on tunnelling dielectric layer 16 at a predetermined interval. Ferroelectric layer 17 is formed on the overall surface of the substrate including floating gate 13. A plurality of wordlines 12 are formed on ferroelectric layer 17 above floating gate 13.

Here, wordlines 12 each are formed to embrace floating gates 13 so that the electrostatic capacity is large between wordlines 12 and floating gates 13 and that capacitance coupling is minimized between the floating gates and bitlines.

High-concentration N-type impurity region 14 is formed on P-type semiconductor substrate 10 between wordlines 12. Interlevel insulating layer 18 is formed on the overall surface of the substrate including wordlines 12, and bitlines 15 are formed on interlevel insulating layer 18. Here, a contact hole is formed on high-concentration N-type impurity region 14, which is coupled to bitline 15.

From now on, a method for fabricating the first embodiment of the present invention will be explained below.

Referring to Figs. 10A and 11A, buffer oxide layer 19, nitride layer 20 and photosensitive layer 21 are deposited sequentially on P-type semiconductor substrate 10, and the field region and active regions are defined by photolithography so that the pattern of photosensitive layer 21 is formed only on the active regions.

Referring to Figs. 10B and 11B, nitride layer 20 is selectively removed by using the pattern of photosensitive layer 21 as a mask and thermally treated under the atmosphere of oxygen so that field insulating layer (field oxide layer) 11 is formed on the field region. Then, photosensitive layer 21, nitride layer 20 and buffer oxide layer 19 are removed.

Referring to Figs. 10C and 11C, tunnelling dielectric layer 16 of PZT is formed on P-type semiconductor substrate 10 on which field insulating layer 11 is formed. Here, tunnelling dielectric layer 16 must be sufficiently thick to enable tunnelling and made of material of a large permittivity. The most appropriate thickness for tunnelling is 70-150Å (10Å = 1nm).

Referring to Figs. 10D and 11D, polysilicon is deposited on tunnelling dielectric layer 16 and patterned by photolithography and etching to thereby form floating gate 13 on tunnelling dielectric layer 16 of the active regions. Here, floating gate 13 may be formed of metal.

Referring to Figs. 10E and 11E, ferroelectric layer 17 is deposited on the overall surface of the substrate including floating gate 13. Here, ferroelectric layer 17 is formed in a stack of oxide/nitride or oxide/nitride/oxide, or formed of PZT.

In Figs. 10F and 11F, polysilicon is deposited on the overall surface of ferroelectric layer 17 and selectively removed by photolithography and etching so that wordlines 12 are formed above floating gate 13. Here, wordlines 12 are formed perpendicular to field insulating layer 11. One row of floating gates 13 are formed to be embraced by wordlines 12. The floating gates may be formed of metal instead of polysilicon.

Turning to Figs. 10G and 11G, N-type impurity ions are heavily implanted into P-type semiconductor substrate 10 of the exposed active regions using wordlines 12 as a mask, to thereby form high-concentration N-type impurity region 14 to be used as a charge in/output stage.

Referring to Figs. 10H and 11H, interlevel insulating layer-18 is deposited on the overall surface of the substrate including wordlines 12, and tunnelling dielectric layer 16, ferroelectric layer 17 and interlevel insulating layer 18 are selectively removed to thereby expose high-concentration N-type impurity region 14 and then form a contact hole.

Referring to Figs. 10I and 11I, polysilicon is deposited on interlevel insulating layer 18 and selectively removed by photolithography and etching to thereby form bitlines 15 to be electrically coupled to high-concentration N-type impurity region 14. Here, bitlines 15 may be formed of metal. According to the above-stated procedures, the first embodiment of the semiconductor memory device of the present invention can be fabricated.

As shown in Figs. 10H and 11H, masking is required to form a bitline contact hole. However, without masking, the first embodiment of the present invention can be made. This method will be explained below.

As shown in Figs. 10E and 11E, this method has the same processes until the process for forming ferroelectric layer 17 on the overall surface of the substrate including floating gate 13. Thereafter, as shown in Fig. 12A, polysilicon 12a and cap insulating layer (oxide layer) 23 are sequentially deposited on the overall surface of ferroelectric layer 17.

Then, as shown in Fig. 12B, using a pattern mask, cap insulating layer 23, polysilicon 12a, ferroelectric layer 17, and tunnelling dielectric layer 16 are selectively removed by photolithography and etching to thereby form wordlines 12. Here, the pattern mask has been used when wordlines 12 are patterned in Figs. 10F and 11F.

Referring to Fig. 12C, N-type impurity ions are heavily implanted onto P-type semiconductor substrate 10 of the exposed active regions using wordlines 12 as a mask so that High-concentration N-type impurity region 14 is formed as the charge in-output stage.

Then, in Fig. 12D, an insulating layer is deposited on the overall surface of the substrate including wordlines 12 and cap insulating layer 23, and etched back to form insulating layer sidewall 24 on the side surface of wordlines 12. Here, insulating layer sidewall 24 is formed on the side surface of wordlines 12 so that, accordingly, a contact hole is formed in high-concentration impurity region 14.

As shown in Fig. 12E, polysilicon is deposited on the overall surface of the substrate including cap insulating layer 23 and insulating layer sidewall 24, and selectively removed by photolithography and etching to form bitlines 15 to be electrically coupled to high-concentration N-type impurity region 14. Therefore, without an additional process of forming the bitline contact hole, the first embodiment of the present invention can be made.

From now on, the second embodiment of the semiconductor memory device and its fabrication method of the present invention will be described.

First, the unit cell of the second embodiment of the semiconductor memory device of the present invention is shown in Fig. 5. In this embodiment, the charge in/output stage is formed only on one side of the stacked gate-MOS capacitor.

The circuit configuration of the second embodiment of the semiconductor memory device of the present invention is shown in Fig. 13. Referring to Fig. 13, this embodiment of the present invention comprises stacked gate-MOS capacitors C11-Cnm arranged in a matrix for programming data and accumulating charges in the substrate according to whether charges are accumulated or not in the floating gate, wordlines WL1-WLm for controlling the same row of the stacked gate-MOS capacitors at the same time, bitlines BL1-BLn for writing and reading data from the same column of the stacked gate-MOS capacitors, and sensing AMPs SA1-SAn for sensing and outputting data from bitlines BL1-BLn. In the stacked gate-MOS capacitor, the charge-in/output stage is formed only on one side of the floating gate. However, the impurity region may be formed on both sides or only one side of the floating gate. Here, in case the impurity region is formed on both sides thereof, one impurity region is coupled to the bitline while used as a charge in/output stage, and the other one is made to float. Accordingly, the control agates of the same row of stacked gate-MOS capacitors are connected to a single wordline. The charge in/output stages are formed only on one side of the same column of stacked gate-MOS capacitors, and connected to a single bitline. Sensing AMPs SA1-SAn each take corresponding bitlines as their input ports. A reference voltage is applied to the other input port of the respective sensing AMPs SA1-SAn. The structure of the second embodiment of the semiconductor memory device of the present invention will be explained below.

First of all, the layout of the second embodiment of the semiconductor of the present invention is shown in Fig. 14 so that a field insulating layer 11 is formed at a predetermined interval on a field area to make a plurality of active regions on the substrate in one direction, and a plurality of wordlines 12 are formed at a predetermined interval on the semiconductor substrate on which field insulating layer 11 is formed, being perpendicular to the active regions.

With the semiconductor substrate placed between field insulating layer 11 as the active regions, a plurality of floating gates 13 are formed between wordlines 12 and the active regions. High-concentration N-type impurity regions 14 are formed on the active regions placed between wordlines 12. A plurality of bitlines 15 are formed between field insulating layers 11, being perpendicular to wordlines 12. Here, high-concentration N-type impurity regions 14 perpendicular to wordlines 12 are connected to a single bit line. Here, as in the first embodiment of the present invention, impurity region 14 is formed on the active regions between the wordlines. The impurity region formed between two wordlines is coupled to a bitline.

Now, the sectional structure of the second embodiment of the semiconductor memory device of the present invention will be described below. Referring to Fig. 15, its section in the direction of wordlines 12 is constructed so that field insulating layer (oxide layer) 11 is formed on P-type semiconductor substrate 10 at a predetermined interval, to thereby make a plurality of active regions. Through this procedure, the field areas and active regions are defined.

A tunnelling dielectric layer 16 is formed on P-type semiconductor substrate 10 of the active regions. A plurality of floating gates 13 are formed on tunnelling dielectric layer 16. Here, floating gates 13 are arranged at a predetermined interval in the matrix.

A ferroelectric layer 17 is formed on the overall surface of the substrate including floating gate 13. Wordlines 12 are formed on ferroelectric layer 17. An interlevel insulating layer 18 is formed on the overall surface of the substrate including wordlines 12. Bitlines 15 are formed on interlevel insulating layer 18 placed above the active regions, being perpendicular to wordlines 12.

Meanwhile, referring to Fig. 16, the sectional structure of the semiconductor memory device of the present invention is constructed so that tunnelling dielectric layer 16 is formed on P-type semiconductor substrate 10, and a plurality of floating gates 13 are formed on tunnelling dielectric layer 16 at a predetermined interval. Ferroelectric layer 17 is formed on the overall surface of the substrate including floating gate 13. A plurality of wordlines 12 are formed on ferroelectric layer 17 above floating gate 13. Here, wordlines 12 each are formed to embrace floating gates 13 so that the electrostatic capacity is large between wordlines 12 and floating gates 13.

High-concentration N-type impurity region 14 is formed on P-type semiconductor substrate 10 between pairs of wordlines 12. Interlevel insulating layer 18 is formed on the overall surface of the substrate including wordlines 12, and bitlines 15 are formed on interlevel insulating layer 18. Here, a contact hole is formed on high-concentration N-type impurity region 14, which is coupled to bitline 15. Though not shown in the drawings, high-concentration impurity region 14 may be formed on the active regions between wordlines 12, and coupled to every other bitline 15.

From now on, a method for fabricating the second embodiment of the present invention will be explained below.

Referring to Figs. 17A and 18A, buffer oxide layer 19, nitride layer 20 and photosensitive layer 21 are deposited sequentially on P-type semiconductor substrate 10, and the field region and active regions are defined by photolithography so that the pattern of photosensitive layer 21 is formed only on the active regions.

Referring to Figs. 17B and 18B, nitride layer 20 is selectively removed by using the pattern of photosensitive layer 21 as a mask and thermally treated under the atmosphere of oxygen so that field insulating layer (field oxide layer) 11 is formed on the field region. Then, photosensitive layer 21, nitride layer 20 and buffer oxide layer 19 are removed.

Referring to Figs. 17C and 18C, tunnelling dielectric layer 16 is formed on P-type semiconductor substrate 10 on which field insulating layer 11 is formed. Here, the thickness of tunnelling dielectric layer 16 is 70-150Å.

Referring to Figs. 17D and 18D, polysilicon is deposited on tunnelling dielectric:layer 16, and floating gate 13 is formed on tunnelling dielectric layer 16 of the active regions by photolithography and etching. Here, floating gate 13 may be formed of metal.

Referring to Figs. 17E and 18E, ferroelectric layer 17 is deposited on the overall surface of the substrate including floating gate 13. Here, ferroelectric layer 17 is formed in an oxide layer, or a stack of oxide/nitride or oxide/nitride/oxide, or formed of PZT.

In Figs. 17F and 18F, polysilicon is deposited on the overall surface of ferroelectric layer 17 and selectively removed by photolithography and etching so that wordlines 12 are formed above floating gate 13. Here, wordlines 12 are formed perpendicular to field insulating layer 11. One row of floating gates 13 are formed to be embraced by wordlines 12. The floating gates may be formed of metal instead of polysilicon.

Turning to Figs. 17G and 18G, photosensitive layer 22 is deposited on the overall surface of the substrate including wordlines 12, and the pattern of photosensitive layer 22 is formed by exposure and development. Here, the pattern of photosensitive layer 22 is made to define the top of every other active region between wordlines 12. Using the pattern of photosensitive layer 22 as a mask, N-type impurity ions are heavily implanted onto P-type semiconductor substrate 10 of the defined active region, to thereby form high-concentration N-type impurity region 14.

Referring to Figs. 17H and 18H, interlevel insulating layer 18 is deposited on the overall surface of the substrate including wordlines 12, and tunnelling dielectric layer 16, ferroelectric layer 17 and interlevel insulating layer 18 are selectively removed to thereby expose high-concentration N-type impurity region 14 and then form a contact hole.

Referring to Figs. 17I and 18I, polysilicon is deposited on interlevel insulating layer 18 and selectively removed by photolithography and etching to thereby form bitlines 15 to be electrically coupled to high-concentration N-type impurity region 14. Here, bitlines 15 may be formed of metal.

Hereinafter, the operation of the semiconductor memory device of the present invention described as above will be explained.

Referring to Figs. 19 and 20, data programming operation will be described first of all. A voltage of 3-5V is applied to bitlines 15 coupled to cells to be not programmed in order to prevent programming. Bitlines 15 to be programmed are grounded.

A pulse of 12-15V is applied to wordlines 12 of cells into which data "0" is written. Wordlines 12 of cells in which data "1" is written are grounded.

In cells whose bitlines 15 are grounded and to whose wordlines 12 a pulse of 12-15V is applied, a voltage of 12-15V is applied to the channel between control gate C.G, that is, wordline, and semiconductor substrate 10. According to Fowler-Nordheim tunnelling, charges of the semiconductor substrate pass through tunneling dielectric layer 16 and are then stored in floating gate 13. In this procedure, data "0" is written.

In cells whose bitlines 15 and wordlines 12 are grounded, no voltage is applied to the channel between control gate C.G, that is, wordline, and semiconductor substrate 10. Charges of the semiconductor substrate are not stored in floating gate 13 and thus write data "1". Here, in cells of bitlines 15 to which a voltage of 3-5V is applied in order to prevent programming, their channel region is inverted even when a pulse of 12-15V is applied to wordlines 12, and a voltage of 3-5V is applied to bitlines 15 so that a voltage sufficient to enable tunneling to floating gate 13 from semiconductor substrate 10 is not applied between wordlines 12 and the substrate and thus charges are not implanted in floating gate 13. After programming of cells connected in one row is finished, cells of another row are programmed sequentially according to the above-stated method. Besides, programming can be performed in another method.

specifically, a pulse of 3-5V is applied to the bitline of cell in which data "0" is to be written, and the bitline of cell in which data "1" is to be written is grounded. Wordlines connected to cells to be not programmed are grounded in order to prevent programming. A voltage of 12V is applied only to wordlines of rows to be programmed.

In floating gate 13 of cells to whose bitline 15 a voltage of 3-5V is applied and to whose wordline 12 a voltage of 12V is applied, charges are accumulated due to tunneling, and the remainder is not stored.

In data erasure, all wordlines 12 are grounded and a voltage of 13-15V is applied to the substrate. The charges stored in floating gate 13 are emitted to the substrate from floating gate 13 via tunneling dielectric layer 16 due to tunneling.

Next, a reading operation will be described below.

It is enabled to read all cells coupled to one wordline 12 at the same time. If necessary, some cells can be selected for reading.

Bitlines 15 to which cells to read are coupled are precharged at a predetermined voltage (for instance, 0V). To wordlines 12 to which cells to read are coupled, a predetermined voltage (for instance, 5V) is applied. Except wordlines 12 to which cells to read are coupled, all wordlines 12 are grounded.

Whether data "0" or "1" is programmed in the respective cells, the voltages of bitlines 15 coupled to the respective cells becomes different. Reading is performed when this voltage difference is detected through the sensing AMPs.

Here, there will be calculated how different the voltages of bitlines coupled to a cell are in reading in case data "0" or data "1" is written in the cell.

First, when data "0" is written in the cell, a predetermined amount of charges, that is, negative charges, are stored in floating gate 13. In this state, as shown in a general stacked gate flash EEPROM, the threshold voltage is increased over 7V when measured in the control gate, that is, wordline 12, because negative charges are accumulated in the floating gate. Therefore, even when a voltage pulse of 5V is applied, an inversion layer is not formed in the cell's channel region. In addition, as shown in Fig. 5A, charges are not emigrated to the cell's channel region from bitlines 15. Wordlines of other cells coupled to the cell's bitlines 15 are grounded so that they are all turned OFF regardless of whether they are programmed with data "0" or "1".

The capacitor response circuit of the bitlines coupled to the cells is roughly shown in Fig. 19. In Fig. 19, voltage $V_{BL("0")}$ output to the sensing AMPs via the bitlines from the cell where data "0" is written by capacitor coupling is given as equation (1).

$$V_{BL("0")} = 5V \cdot C1 / (MC1 + C_{BL}) \quad (1)$$

where

C1 is a capacitance produced when wordline 12 and impurity region 14 are overlapped;
C2 is a capacitance between wordline 12 and floating gate 13;
C3 is a capacitance between floating gate 13 and semiconductor substrate 10;
M is the number of cell coupled to one bitline; and
$C_{BL}$ is a junction capacitance between all impurity regions coupled to one bitline and the semiconductor substrate.

Second, in case data "1" is written in the cell, charges are not accumulated in floating gate 13 so that a threshold voltage measured at wordline 12 is lowered to about 1-2V. After 5V of voltage pulse is applied to wordline 12, a strong inversion layer is formed in the channel of the substrate corresponding to the cell so that the voltage of bitline 15 is applied to the channel region of the cell, as shown in Fig. 5B. In this case, the capacitor response circuit of the bitline is shown as in Fig. 20. Voltage/$V_{BL("1")}$ output to the sensing AMP by the cell via the bitline is roughly expressed as in equation (2).

$$V_{BL("1")} \fallingdotseq 5V \cdot (C1 + C2 /// C3) / (MC1 + C_{BL} + C2 /// C3) \quad (2)$$

where C2 /// C3 = C2 X C3 / (C2 + C3).

From equations (1) and (2), voltage $\Delta V_{BL}$ is expressed as follows.

$$\Delta V_{bit} = V_{BL("1")} - V_{BL("0")}$$

$$= 5V \cdot (C1 + C2 /// C3) / (MC1 + C_{BL} + C2 /// C3.) \quad (3)$$

In equation (3), if (C2 /// C3) $\fallingdotseq$ 10 C1, the number of cell is 1,000, and $C_{BL}$ is ignored,

$$\Delta V_{bit} = 5V \cdot 10Cl / (1{,}000\ C1 + 10\ C1) = 50/1010 \fallingdotseq 50mV. \quad (4)$$

As a result, the difference between the voltage when data "0" is written and the voltage when data "1" is written is as indicated in equation (4). In a general sensing AMP, reading data "1" or data "0" is enabled when there is a voltage difference of about 20mV. Therefore, the present invention is sufficiently capable of reading data.

As described above, the semiconductor memory device of the present invention involves the following advantages.

First, when data stored in the cell is erased, the control gate is grounded and a voltage pulse of 12-15V is applied to the substrate so that charges accumulated in the floating gate are discharged to the substrate therefrom. This hardly produces hot holes on the substrate in erasure, solving overerasure.

Secondly, for the conventional ETOX flash EEPROM, the source junction is deeply formed in order to prevent hot holes, increasing the size of unit cell. However, in the present invention, the junction is not deeply formed and only one impurity region coupled to the bitlines is formed for every unit cell, sharply reducing the area of unit cell and therefore enhancing its packing density.

Thirdly, in case of the conventional ETOX flash EEPROM, a voltage applied to the bitlines is generally 6-8V in programming. In the present invention, a voltage applied to the bitlines in programming is a maximum of 5V so that loss of charges stored in the floating gate can be prevented in programming.

Fourthly, for the conventional ETOX flash EEPROM, programming is performed by channel hot electron injection so that a lot of current of 10μA runs through cells to program. In the present invention, programming is performed by Fowler Nordheim tunnelling so that several pAs of current flows.

Fifthly, the unit cell of the present invention is made with a stacked gate-MOS capacitor, requiring no channel for carrying charges and thus preventing punch-through between source and drain. Accordingly, the doping concentration of the impurity region is reduced more sharply than that of MOSFET, greatly reducing junction capacitance for every cell.

## Claims

1. A semiconductor memory device comprising at least:

   - a first conductivity-type semiconductor substrate (10):
   - a first, floating gate, electrode (13) formed on a dielectric layer (16) on said semiconductor substrate (10) for charging/discharging of charges;
   - a second, control gate, electrode (12) formed on a ferroelectric layer (17) above said first electrode so as to surround said first electrode placed thereunder to controll charging/discharging and data reading/writing of said first electrode (13); and
   - a charge in/output stage (14) formed on said semiconductor substrate (10) at least on one side of said second electrode (12) for supplying said charges,

   wherein said charge in/output stage (14) and said second electrode (12) are overlapped to form a third capacitor.

2. The semiconductor memory device as claimed in claim 1, wherein said charge in/output stage (14) is formed on said substrate (10) on both sides of said second electrode (12).

3. The semiconductor memory device as claimed in claim 1, wherein an impurity region is formed on said substrate (10) on both sides of said second electrode (12) so as to form said charge in/output stage (14).

4. The semiconductor memory device as claimed in claim 1, 2 or 3, wherein bitlines (15) are coupled to said charge in/output stage (14).

5. The semiconductor memory device as claimed in claim 1, 2, 3 or 4, wherein said semiconductor substrate (10) is P-type, and said charge in/output stage (14) is high-concentration N-type.

6. The semiconductor memory device as claimed in claim 1, wherein

   the first conductivity-type semiconductor substrate (10) is used as one electrode of a first capacitor;

   the first electrode (13) formed on said semiconductor substrate (10) is used as the other electrode of said first capacitor and as one electrode of a second capacitor;

   the second electrode (12) formed on said first electrode (13) is used as the other electrode of said second capacitor; and

   the charge in/output stage (14) is formed on said semiconductor substrate (10) on one side of said second electrode (12) for supplying charges to be accumulated in said first electrode (13).

7. The semiconductor memory device as claimed in claim 6, wherein said charge in/output stage (14) is high-concentration second conductivity-type.

8. The semiconductor memory device as claimed in claim 6, wherein said charge in/output stage (14) is high-concentration N-type.

9. The semiconductor memory device as claimed in one of the claims 1 to 8, comprising at least one unit cell formed in the form of a stacked gate-MOS capacitor in which the first electrode (13) or floating gate and the second electrode (12) or control gate are stacked on the substrate (10), and the impurity region used as a charge in/output stage (14) is formed on said substrate (10) and placed on one side of said control gate (12).

10. The semiconductor memory device as claimed in claim 9, comprising:

a plurality of stacked gate-MOS capacitors (Cmn) arranged in the form of matrix;
a plurality of wordlines (WL) for controlling the same row of the stacked gate-MOS capacitors (Cmn) at the same time;
a plurality of bitlines (BL) for writing and reading data from the same column of the stacked gate-MOS capacitors (Cmn); and
a plurality of sensing amplifiers (SA) for sensing and outputting data from said bitlines (BL).

11. The semiconductor memory device as claimed in claim 10, wherein the control gates (12) of the same row of stacked gate-MOS capacitors are connected to a single wordline (WL), the charge in/output stages (14) of the same column of stacked gate-MOS capacitors are connected to a single bitline (BL) and said sensing amplifiers (SA) taking corresponding bitline (BL) as its input port and receiving a reference voltage ($V_{ref}$) via its other input port.

12. The semiconductor memory device as claimed in claim 1, wherein on the first conductivity-type semiconductor substrate (10) a field insulating layer (11) is formed so that a plurality of active regions are formed in one direction at a predetermined interval;
a plurality of second electrodes (12) is formed as wordlines above said semiconductor substrate (10) at a predetermined interval, perpendicular to said active regions;
a plurality of first electrodes (13) is formed as floating gates between said wordlines (12) and the semiconductor substrate (10) in the active regions;
the charge in/output stages (14) are formed on the active regions between said wordlines (12); and
a plurality of bitlines (15) is formed on said wordlines (12) above said active regions, perpendicular to said wordlines (12).

13. The semiconductor memory device as claimed in claim 12, wherein said charge in/output stage (14) is formed on the active regions placed between every two wordlines (12).

14. The semiconductor memory device as claimed in claim 12, wherein said charge in/output stage (14) is high-concentration second conductivity-type.

15. The semiconductor memory device as claimed in claim 12, wherein said charge in/output stages (14) formed on the same active region are coupled to a single bitline (15).

16. The semiconductor memory device as claimed in claim 1, wherein on the first conductivity-type semiconductor substrate (10) a field insulating layer (11) is formed in a field region so that a plurality of active regions is formed in one direction at a predetermined interval;
a plurality of charge in/output stages (14) is formed on said semiconductor substrate (10) in said active regions at a predetermined interval;
a tunnelling dielectric layer (16) is formed on said semiconductor substrate (10), said layer (16) having a contact hole in said charge in/output stage (14) ;
a plurality of first electrodes or floating gates (13) is formed in matrix on said tunnelling dielectric layer (16) above said active regions between said charge in/output stages (14) ;
a ferroelectric layer (17) is formed on the overall surface of said substrate (10) including said floating gates (13), said layer (17) having a contact hole in said charge in/output stage (14);
a plurality of second electrodes or wordlines(12) is formed on said ferroelectric layer (17) above said floating gates (13) perpendicular to said active regions;
an interlevel insulating layer (18) is formed on the overall surface of said substrate (10) including said wordlines (12), said layer (18) having a contact hole in said charge in/output stage (14); and
a plurality of bitlines (15) is formed on said interlevel insulating layer (18) to thereby electrically connect said charge in/output stages (14) formed on the same active region.

**17.** The semiconductor memory device as claimed in claim 16, wherein two floating gates are formed on said tunnelling dielectric layer (16) above the active regions placed between said charge in/output stages (14).

**18.** The semiconductor memory device as claimed in claim 16, wherein said tunnelling dielectric layer (16), ferroelectric layer (17) and interlevel insulating layer (18) are formed to have a contact hole for every other charge in/output stage (14).

**19.** The semiconductor memory device as claimed in claim 16, wherein said tunnelling dielectric layer (16) is formed of PZT.

**20.** The semiconductor memory device as claimed in claim 16, wherein said wordlines (12) are formed to surround the respective floating gates (13).

**21.** The semiconductor memory device as claimed in claim 16, wherein said tunnelling dielectric layer (16) is formed by the thickness of 7 -15 nm.

**22.** The semiconductor memory device as claimed in claim 16, wherein said ferroelectric layer (17) is formed in an oxide layer, a stack of oxide/nitride or oxide/nitride/oxide, or PZT.

**23.** A method for fabricating a semiconductor memory device, comprising the steps of:

- forming a tunneling dielectric layer (16) on a semiconductor substrate (10);
- forming a floating gate (13) on said tunneling dielectric layer (16),
- forming a ferroelectric layer (17) on the overall surface of said substrate (10) including said floating gate (13);
- forming a control gate (12) on said ferroelectric layer (17) above said floating gate (13) so as to surround that floating gate (13) placed thereunder; and
- forming a charge in/output stage (14) at least on one side of said control gate (12) so as to form a third capacitor.

**24.** The method for fabricating a semiconductor memory device as claimed in claim 23, wherein said charge in/output stage (14) is formed on both sides of said control gate (12).

**25.** The method for fabricating a semiconductor memory device as claimed in claim 23, wherein said charge in/output stage (14) is formed by implanting high-concentration N-type impurity ions, using said control gate (12) as a mask.

**26.** The method for fabricating a semiconductor memory device as claimed in claim 23, wherein said floating gate (13) is formed of polysilicon or metal.

**27.** The method for fabricating a semiconductor memory device as claimed in claim 23, wherein said control gate (12) is formed of polysilicon or metal.

**28.** The method for fabricating a semiconductor memory device as claimed in claim 23, wherein said tunnelling dielectric layer (16) is formed by deposing PZT.

**29.** The method for fabricating a semiconductor memory device as claimed in claim 23, wherein said tunnelling dielectric layer (16) is formed by the thickness of 7 -15 nm.

**30.** The method for fabricating a semiconductor memory device as claimed in claim 23, wherein said ferroelectric dielectric layer (17) is formed in an oxide layer or a stack of oxide/nitride.

**31.** The method for fabricating a semiconductor memory device as claimed in claim 23, wherein said ferroelectric dielectric layer (17) is formed in an oxide layer or a stack of oxide/nitride/oxide.

**32.** The method for fabricating a semiconductor memory device as claimed in claim 23, wherein said ferroelectric dielectric layer (17) is formed by deposing PZT.

**33.** The method for fabricating a semiconductor memory device as claimed in claim 23, comprising the steps of:

forming prior to the tunnelling dielectric layer (16) a field insulating layer (11) in a field region so that a plurality of active regions is formed in one direction at a predetermined interval on the first conductivity-type semiconductor substrate (10);
forming a plurality of floating gates (13) on said tunnelling dielectric layer (16) above said active regions at a predetermined interval;
forming the ferroelectric dielectric layer (17) on the overall surface of said substrate (10) including said plurality of floating gates (13);
forming a plurality of control gates or wordlines (12) on said ferroelectric dielectric layer (17) so that one wordline (12) controls said floating gates (13) perpendicular to said active regions;
forming the charge in/output stages (14) or high-concentration second conductivity-type impurity regions in said active regions between said wordlines (12);
depositing an interlevel insulating layer (18) on the overall surface of said substrate (10) including said wordlines (12), and
forming a contact hole so that high-concentration second conductivity-type impurity regions (14) are exposed; and forming a plurality of bitlines (15) on said interlevel insulating layer (18) to thereby be electrically coupled to said high-concentration second conductivity-type impurity regions (14).

**34.** The method for fabricating a semiconductor memory device as claimed in claim 33, wherein said contact hole is formed for each high-concentration impurity region (14).

**35.** The method for fabricating a semiconductor memory device as claimed in claim 33, wherein said semiconductor substrate (10) uses P-type, and said impurity region (14) is formed as N-type.

**36.** The method for fabricating a semiconductor memory device as claimed in claim 33, wherein said wordlines (12) are formed to surround said floating gates (13) placed thereunder.

**37.** The method for fabricating a semiconductor memory device as claimed in claim 23, comprising the steps of:

forming prior to the tunnelling dielectric layer (16) a field insulating layer (11) in a field region so that a plurality of active regions is formed in one direction at a predetermined interval on the first conductivity-type semiconductor substrate (10);
forming a plurality of floating gates (13) on said tunnelling dielectric layer (16) above said active regions at a predetermined interval;
forming a ferroelectric dielectric layer (17) on. the overall surface of said substrate (10) including said plurality of floating gates (13);
forming a plurality of control gates or wordlines (12) stacked by a cap insulating layer (23) on said ferroelectric dielectric layer (17) so that one wordline (12) controls said floating gates (13) perpendicular to said active regions;
forming the charge in/output stages (14) or impurity regions on said active regions between said wordlines (12);
selectively removing said ferroelectric dielectric layer (17) and tunnelling dielectric layer (16), using said wordlines (12) as a mask;
forming an insulating layer sidewall (24) on the side surface of said wordlines (12) and-cap insulating layers (23) to thereby form a contact hole on said impurity regions (14); and
forming a plurality of bitlines (15) to thereby be electrically coupled to said impurity regions (14).

**38.** The method for fabricating a semiconductor memory device as claimed in claim 37, wherein said wordline forming step is performed so that a conductive layer and insulating layer are sequentially deposited on said ferroelectric dielectric layer (17) and selectively removed by photolithography and etching, thereby forming a wordline (12) above said floating gates (13) perpendicular to said active regions.

**39.** The method for fabricating a semiconductor memory device as claimed in claim 37, wherein said cap insulating layer (23) is formed of a material having a large etching selection ratio between said tunnelling dielectric layer (16) and ferroelectric dielectric layer (17).

**40.** The method for fabricating a semiconductor memory device as claimed in claim 37, wherein said insulating layer sidewall (24) is formed by deposing and anisotropically etching an insulating layer on the overall surface of said substrate (10) including said wordline (12) and cap insulating layer (23).

**41.** The method for fabricating a semiconductor memory device as claimed in claim 40, wherein the deposition thickness of said insulating layer is controlled in consideration of the radius of said contact hole.

**42.** The method for fabricating a semiconductor memory device as claimed in claim 23 comprising the steps of:

forming prior to the tunnelling dielectric layer (16) a field insulating layer (11) in a field region so that a plurality of active regions are formed in one direction at a predetermined interval on the first conductivity-type semiconductor substrate (10);
forming a plurality of floating gates (13) on said tunnelling dielectric layer (16) above said active regions at a predetermined interval;
forming a ferroelectric dielectric layer (17) on the overall surface of said substrate (10) including said floating gates (13);
forming a plurality of control gates or wordlines (12) on said ferroelectric dielectric layer (17) so that one wordline (12) controls said floating gates (13) perpendicular to said active regions;
alternately forming maskings between said wordlines (12);
forming the charge in/output stages (14) or high-concentration second conductivity-type impurity regions on said active regions, using said wordlines (12) and maskings as a mask;
depositing an interlevel insulating layer (18) on the overall surface of said substrate (10) including said wordlines (12), and forming a contact hole to expose said high-concentration second conductivity-type impurity regions (14); and
forming a plurality of bitlines (15) on said interlevel insulating layer (18) to thereby be electrically coupled to said high-concentration second conductivity-type impurity regions (14).

**43.** The method for fabricating a semiconductor memory device as claimed in claim 23, comprising the steps of:

forming prior to the tunnelling dielectric layer (16) a field insulating layer (11) in a field region so that a plurality of active regions is formed in one direction at a predetermined interval on the first conductivity-type semiconductor substrate (10);
forming a plurality of floating gates (13) on said tunnelling dielectric layer (16) above said active regions at a predetermined interval;
forming a ferroelectric dielectric layer (17) on the overall surface of said substrate (10) including said floating gates (13);
forming a plurality of control gates or wordlines (12) stacked by a cap insulating layer (23) on said ferroelectric dielectric layer (17) so that one wordline (12) controls said floating gates (13) perpendicular to said active regions;
alternately forming maskings between said wordlines (12);
forming the charge in/output stages (14) or impurity regions on said active regions, using said wordlines (12) and maskings as a mask;
selectively removing said ferroelectric dielectric layer (17) and tunnelling dielectric layer (16), using said wordlines (12) and maskings as a mask;
forming an insulating layer sidewall (23) on the side of said wordlines (12) and cap insulating layer (23), thereby forming a contact hole on said impurity regions (14); and
forming a plurality of bitlines (15) to thereby be electrically coupled to said impurity regions (14).

**44.** The method for fabricating a semiconductor memory device as claimed in claim 43, wherein said masking, insulating layer sidewall (23), ferroelectric dielectric layer (17) or tunnelling insulating layer (16) is formed of a material having a large etching selection ratio therebetween.

## Patentansprüche

**1.** Halbleiter-Speicherbauteil mit mindestens:

- einem Halbleitersubstrat (10) von einem ersten Leitungstyp;
- einer ersten Elektrode (13), nämlich einer Floatgateelektrode, die auf einer dielektrischen Schicht (16) auf dem Halbleitersubstrat (10) ausgebildet ist, um Ladungen zu laden/zu entladen;
- einer zweiten Elektrode (12), oder einer Steuergateelektrode, die auf einer ferroelektrischen Schicht (17) über der ersten Elektrode so ausgebildet ist, dass sie diese umgibt, die darunter platziert ist, um das Laden/Entladen und das Lesen/Schreiben von Daten betreffend die erste Elektrode (13) zu kontrollieren; und

- einer Ladungen-Eingangs/Ausgangs-Stufe (14), die auf dem Halbleitersubstrat (10) auf mindestens einer Seite der zweiten Elektrode (12) ausgebildet ist, um die genannten Ladungen zu liefern, wobei diese Ladungen-Eingangs/Ausgangs-Stufe (14) und die zweite Elektrode (12) überlappen, um einen dritten Kondensator zu bilden.

**2.** Halbleiter-Speicherbauteil nach Anspruch 1, bei dem die Ladungen-Eingangs/Ausgangs-Stufe (14) zu beiden Seiten der zweiten Elektrode (12) auf dem Substrat (10) ausgebildet ist.

**3.** Halbleiter-Speicherbauteil nach Anspruch 1, bei dem auf dem Substrat (10) zu beiden Seiten der zweiten Elektrode (12) ein Fremdstoffbereich ausgebildet ist, um die Ladungen-Eingangs/Ausgangs-Stufe (14) zu bilden.

**4.** Halbleiter-Speicherbauteil nach Anspruch 1, 2 oder 3, bei dem Bitleitungen (15) mit der Ladungen-Eingangs/Ausgangs-Stufe (14) verbunden sind.

**5.** Halbleiter-Speicherbauteil nach Anspruch 1, 2, 3 oder 4, bei dem das Halbleitersubstrat (10) vom p-Typ ist und die Ladungen-Eingangs/Ausgangs-Stufe (14) vom n-Typ mit hoher Konzentration ist.

**6.** Halbleiter-Speicherbauteil nach Anspruch 1, bei dem:

- das Halbleitersubstrat (10) vom ersten Leitungstyp als eine Elektrode eines ersten Kondensators verwendet ist;
- die auf dem Halbleitersubstrat (10) hergestellte erste Elektrode (13) als andere Elektrode des ersten Kondensators und als eine Elektrode eines zweiten Kondensators verwendet ist;
- die auf der ersten Elektrode (13) hergestellte zweite Elektrode (12) als andere Elektrode des zweiten Kondensators verwendet ist; und
- die Ladungen-Eingangs/Ausgangs-Stufe (14) auf einer Seite der zweiten Elektrode (12) auf dem Halbleitersubstrat (10) hergestellt ist, um Ladungen zu liefern, die in der ersten Elektrode (13) anzusammeln sind.

**7.** Halbleiter-Speicherbauteil nach Anspruch 6, bei dem die Ladungen-Eingangs/Ausgangs-Stufe (14) vom zweiten Leitungstyp ist und hohe Konzentration aufweist.

**8.** Halbleiter-Speicherbauteil nach Anspruch 6, bei dem die Ladungen-Eingangs/Ausgangs-Stufe (14) vom n-Typ ist und hohe Konzentration aufweist.

**9.** Halbleiter-Speicherbauteil nach einem der Ansprüche 1 bis 8, mit mindestens einer Einheitszelle, die in Form eines Schichtgate-MOS-Kondensators ausgebildet ist, bei dem die erste Elektrode (13) oder das Floatgate und die zweite Elektrode (12) oder das Steuergate (10) aufgeschichtet sind und der als Ladungen-Eingangs/Ausgangs-Stufe (14) verwendete Fremdstoffbereich auf dem Substrat (10) ausgebildet ist und auf einer Seite des Steuergates (12) platziert ist.

**10.** Halbleiter-Speicherbauteil nach Anspruch 9, mit:

- mehreren Schichtgate-MOS-Kondensatoren (Cmn), die in Matrixform angeordnet sind;
- mehreren Wortleitungen (WL) zum Kontrollieren derselben Zeile von Schichtgate-MOS-Kondensatoren (Cmn) zum selben Zeitpunkt;
- mehreren Bitleitungen (BL) zum Schreiben und Lesen von Daten auf derselben Spalte von Schichtgate-MOS-Kondensatoren (Cmn); und
- mehreren Leseverstärkern (SA) zum Lesen und Ausgeben von Daten von den Bitleitungen (BL).

**11.** Halbleiter-Speicherbauteil nach Anspruch 10, bei dem die Steuergates (12) derselben Zeile von Schichtgate-MOS-Kondensatoren mit einer einzelnen Wortleitung (WL) verbunden sind, die Ladungen-Eingangs/Ausgangs-Stufen (14) derselben Spalte von Schichtgate-MOS-Kondensatoren mit einer einzelnen Bitleitung (BL) verbunden sind und die Leseverstärker (SA) eine entsprechende Bitleitung (BL) als Eingangsport verwenden und sie über ihren anderen Eingangsport eine Bezugsspannung ($V_{ref}$) empfangen.

**12.** Halbleiter-Speicherbauteil nach Anspruch 1, bei dem

- auf dem Halbleitersubstrat (10) vom ersten Leitungstyp eine Feld-Isolierschicht (11) so ausgebildet ist, dass in einer Richtung mit einem vorbestimmten Intervall mehrere aktive Bereiche ausgebildet sind;
- mehrere zweite Elektroden (12) als Wortleitungen mit einem vorbestimmten Intervall über dem Halbleitersubstrat (10) rechtwinklig zu den aktiven Bereichen ausgebildet sind;
- mehrere erste Elektroden (13) als Floatgate zwischen den Wortleitungen (12) und dem Halbleitersubstrat (10) in den aktiven Bereichen ausgebildet sind;
- die Ladungen-Eingangs/Ausgangs-Stufen (14) auf den aktiven Bereichen zwischen den Wortleitungen (12) ausgebildet sind; und
- auf den Wortleitungen (12) über den aktiven Bereichen mehrere Bitleitungen (15) rechtwinklig zu den Wortleitungen (12) ausgebildet sind.

**13.** Halbleiter-Speicherbauteil nach Anspruch 12, bei dem die Ladungen-Eingangs/Ausgangs-Stufe (14) auf den aktiven Bereichen, die zwischen jeweils zwei Wortleitungen (12) platziert sind, ausgebildet ist.

**14.** Halbleiter-Speicherbauteil nach Anspruch 12, bei dem die Ladungen-Eingangs/Ausgangs-Stufe (14) vom zweiten Leitungstyp ist und hohe Konzentration aufweist.

**15.** Halbleiter-Speicherbauteil nach Anspruch 12, bei dem die auf demselben aktiven Bereich ausgebildeten Ladungen-Eingangs/Ausgangs-Stufen (14) mit einer einzelnen Bitleitung (15) verbunden sind.

**16.** Halbleiter-Speicherbauteil nach Anspruch 1, bei dem

- auf dem Halbleitersubstrat (10) vom ersten Leitungstyp eine Feld-Isolierschicht (11) in einem Feldbereich so ausgebildet ist, dass mehrere aktive Bereiche in einer Richtung mit einem vorbestimmten Intervall ausgebildet sind;
- mehrere Ladungen-Eingangs/Ausgangs-Stufen (14) auf dem Halbleitersubstrat (10) in den aktiven Bereichen mit einem vorbestimmten Intervall ausgebildet sind;
- auf dem Halbleitersubstrat (10) eine dielektrische Tunnelschicht (16) ausgebildet ist, die in der Ladungen-Eingangs/Ausgangs-Stufe (14) ein Kontaktloch aufweist; und
- mehrere erste Elektroden oder Floatgates (13) in einer Matrix auf der dielektrischen Tunnelschicht (16) über den aktiven Bereichen zwischen den Ladungen-Eingangs/Ausgangs-Stufen (14) ausgebildet sind;
- eine ferroelektrische Schicht (17) auf der gesamten Oberfläche des Substrats (10) einschließlich der Floatgates (13) ausgebildet ist, die in der Ladungen-Eingangs/Ausgangs-Stufe (14) ein Kontaktloch aufweist;
- mehrere zweite Elektroden oder Wortleitungen (12) auf der ferroelektrischen Schicht (17) über den Floatgates (13) rechtwinklig zu den aktiven Bereichen ausgebildet sind;
- eine Zwischenschicht-Isolierschicht (18) auf der gesamten Oberfläche des Substrats (10) einschließlich der Wortleitungen (12) ausgebildet ist, die in der Ladungen-Eingangs/Ausgangs-Stufe (14) ein Kontaktloch aufweist; und
- mehrere Bitleitungen (15) auf der Zwischenschicht-Isolierschicht (18) ausgebildet sind, um dadurch die auf demselben Bereich ausgebildeten Ladungen-Eingangs/Ausgangs-Stufen (14) elektrisch zu verbinden.

**17.** Halbleiter-Speicherbauteil nach Anspruch 16, bei dem auf der dielektrischen Tunnelschicht (16) über den aktiven Bereichen, die zwischen den Ladungen-Eingangs/Ausgangs-Stufen (14) platziert sind, zwei Floatgates ausgebildet sind.

**18.** Halbleiter-Speicherbauteil nach Anspruch 16, bei dem die dielektrische Tunnelschicht (16), die ferroelektrische Schicht (17) und die Zwischenschicht-Isolierschicht (18) so ausgebildet sind, dass sie für jede übernächste Ladungen-Eingangs/Ausgangs-Stufe (14) ein Kontaktloch aufweisen.

**19.** Halbleiter-Speicherbauteil nach Anspruch 16, bei dem die ferroelektrische Tunnelschicht (16) aus PZT besteht.

**20.** Halbleiter-Speicherbauteil nach Anspruch 16, bei dem die Wortleitungen (12) so ausgebildet sind, dass sie die jeweiligen Floatgates (13) umgeben.

**21.** Halbleiter-Speicherbauteil nach Anspruch 16, bei dem die ferroelektrische Tunnelschicht (16) mit einer Dicke von 7 - 15 nm ausgebildet ist.

**22.** Halbleiter-Speicherbauteil nach Anspruch 16, bei dem die ferroelektrische Schicht (17) als Oxidschicht, als Oxid/Nitrid- oder Oxid/Nitrid/Oxid-Stapel oder aus PZT hergestellt ist.

**23.** Verfahren zum Herstellen eines Halbleiter-Speicherbauteils, mit den folgenden Schritten:

- Herstellen einer dielektrischen Tunnelschicht (16) auf einem Halbleitersubstrat (10);
- Herstellen eines Floatgates (13) auf der dielektrischen Tunnelschicht (16);
- Herstellen einer ferroelektrischen Schicht (17) auf der gesamten Oberfläche des Substrats (10) einschließlich des Floatgates (13);
- Herstellen eines Steuergates (12) auf der ferroelektrischen Schicht (17) über dem Floatgate (13) in solcher Weise, dass es das darunter platzierte Floatgate (13) umgibt; und
- Herstellen einer Ladungen-Eingangs/Ausgangs-Stufe (14) auf mindestens einer Seite des Steuergates (12), um einen dritten Kondensator zu bilden.

**24.** Verfahren zum Herstellen eines Halbleiter-Speicherbauteils nach Anspruch 23, bei dem die Ladungen-Eingangs/ Ausgangs-Stufe (14) auf beiden Seiten des Steuergates (12) hergestellt wird.

**25.** Verfahren zum Herstellen eines Halbleiter-Speicherbauteils nach Anspruch 23, bei dem die Ladungen-Eingangs/ Ausgangs-Stufe (14) durch Implantieren von n-Fremdstoffionen mit hoher Konzentration unter Verwendung des Steuergates (12) als Maske hergestellt wird.

**26.** Verfahren zum Herstellen eines Halbleiter-Speicherbauteils nach Anspruch 23, bei dem das Floatgate (13) aus Polysilicium oder Metall hergestellt wird.

**27.** Verfahren zum Herstellen eines Halbleiter-Speicherbauteils nach Anspruch 23, bei dem das Steuergate (12) aus Polysilicium oder Metall hergestellt wird.

**28.** Verfahren zum Herstellen eines Halbleiter-Speicherbauteils nach Anspruch 23, bei dem die dielektrische Tunnelschicht (16) durch Abscheiden von PZT hergestellt wird.

**29.** Verfahren zum Herstellen eines Halbleiter-Speicherbauteils nach Anspruch 23, bei dem die dielektrische Tunnelschicht (16) mit einer Dicke von 7 - 15 nm hergestellt wird.

**30.** Verfahren zum Herstellen eines Halbleiter-Speicherbauteils nach Anspruch 23, bei dem die ferroelektrische Dielektrikumsschicht (17) als Oxidschicht oder als Oxid/Nitridstapel hergestellt wird.

**31.** Verfahren zum Herstellen eines Halbleiter-Speicherbauteils nach Anspruch 23, bei dem die ferroelektrische Dielektrikumsschicht (17) als Oxidschicht oder als Oxid/Nitrid-/Oxid-Stapel hergestellt wird.

**32.** Verfahren zum Herstellen eines Halbleiter-Speicherbauteils nach Anspruch 23, bei dem die ferroelektrische Dielektrikumsschicht (17) durch Abscheiden von PZT hergestellt wird.

**33.** Verfahren zum Herstellen eines Halbleiter-Speicherbauteils nach Anspruch 23, mit den folgenden Schritten:

- Herstellen, vor der dielektrischen Tunnelschicht (16), einer Feld-Isolierschicht (11) in einem Feldbereich in solcher Weise, dass in einer Richtung mit einem vorbestimmten Intervall mehrere aktive Bereiche auf dem Halbleitersubstrat (10) vom ersten Leitungstyp ausgebildet werden;
- Herstellen mehrerer Floatgates (13) mit einem vorbestimmten Intervall auf der dielektrischen Tunnelschicht (16) über dem aktiven Bereich;
- Herstellen der ferroelektrischen Dielektrikumsschicht (17) auf der gesamten Oberfläche des Substrats (10) einschließlich der mehreren Floatgates (13);
- Herstellen mehrerer Steuergates oder Wortleitungen (12) auf der ferroelektrischen Dielektrikumsschicht (17) in solcher Weise, dass eine Wortleitung (12) die Floatgates (13) rechtwinklig zu den aktiven Bereichen kontrolliert;
- Herstellen der Ladungen-Eingangs/Ausgangs-Stufen (14) oder von Fremdstoffbereichen hoher Konzentration vom zweiten Leitungstyp in den aktiven Bereichen zwischen den Wortleitungen (12);
- Abscheiden einer Zwischenschicht-Isolierschicht (18) auf der gesamten Oberfläche des Substrats (10) einschließlich der Wortleitungen (12); und
- Herstellen eines Kontaktlochs in solcher Weise, dass Fremdstoffbereiche (14) hoher Konzentration vom zweiten Leitungstyp freigelegt werden; und

- Herstellen mehrerer Bitleitungen (15) auf der Zwischenschicht-Isolierschicht (18), so dass sie dadurch elektrisch mit den Fremdstoffbereichen (14) hoher Konzentration vom zweiten Leitungstyp verbunden sind.

**34.** Verfahren zum Herstellen eines Halbleiter-Speicherbauteils nach Anspruch 33, bei dem das Kontaktloch für jeden Fremdstoffbereich (14) hoher Konzentration ausgebildet wird.

**35.** Verfahren zum Herstellen eines Halbleiter-Speicherbauteils nach Anspruch 33, bei dem für das Halbleitersubstrat (10) der p-Typ verwendet wird und der Fremdstoffbereich (14) als n-Typ hergestellt wird.

**36.** Verfahren zum Herstellen eines Halbleiter-Speicherbauteils nach Anspruch 33, bei dem die Wortleitungen (12) so hergestellt werden, dass sie die darunter platzierten Floatgates (13) umgeben.

**37.** Verfahren zum Herstellen eines Halbleiter-Speicherbauteils nach Anspruch 23, mit den folgenden Schritten:

- Herstellen, vor der dielektrischen Tunnelschicht (16), einer Feld-Isolierschicht (11) in einem Feldbereich in solcher Weise, dass in einer Richtung mit einem vorbestimmten Intervall mehrere aktive Bereiche auf dem Halbleitersubstrat (10) vom ersten Leitungstyp ausgebildet werden;
- Herstellen mehrerer Floatgates (13) mit einem vorbestimmten Intervall auf der dielektrischen Tunnelschicht (16) über dem aktiven Bereich;
- Herstellen der ferroelektrischen Dielektrikumsschicht (17) auf der gesamten Oberfläche des Substrats (10) einschließlich der mehreren Floatgates (13);
- Herstellen mehrerer Steuergates oder Wortleitungen (12), auf die eine Deck-Isolierschicht (23) gestapelt ist, auf der ferroelektrischen Dielektrikumsschicht (17) in solcher Weise, dass eine Wortleitung (12) die Floatgates (13) rechtwinklig zu den aktiven Bereichen kontrolliert;
- Herstellen der Ladungen-Eingangs/Ausgangs-Stufen (14) oder von Fremdstoffbereichen hoher Konzentration vom zweiten Leitungstyp auf den aktiven Bereichen zwischen den Wortleitungen (12);
- selektives Entfernen der ferroelektrischen Dielektrikumsschicht (17) und der dielektrischen Tunnelschicht (16) unter Verwendung der Wortleitungen (12) als Maske;
- Herstellen einer Isolierschicht-Seitenwand (24) auf der Seitenfläche der Wortleitung (12) und der Deck-Isolierschichten (23), um dadurch auf den Fremdstoffbereichen (14) ein Kontaktloch auszubilden; und
- Herstellen mehrerer Bitleitungen (15), die dadurch elektrisch mit den Fremdstoffbereichen (14) verbunden sind.

**38.** Verfahren zum Herstellen eines Halbleiter-Speicherbauteils nach Anspruch 37, bei dem der Schritt des Herstellens der Wortleitung so ausgeführt wird, dass eine leitende Schicht und eine Isolierschicht sequenziell auf der ferroelektrischen Dielektrikumsschicht (17) abgeschieden werden und sie durch Fotolithografie und Ätzen selektiv entfernt werden, um dadurch über den Floatgates (13) eine Wortleitung (12) rechtwinklig zu den aktiven Bereichen auszubilden.

**39.** Verfahren zum Herstellen eines Halbleiter-Speicherbauteils nach Anspruch 37, bei dem die Deck-Isolierschicht (23) aus einem Material mit Ätzselektivitätsverhältnis zwischen der dielektrischen Isolierschicht und der ferroelektrischen Dielektrikumsschicht (17) hergestellt wird.

**40.** Verfahren zum Herstellen eines Halbleiter-Speicherbauteils nach Anspruch 37, bei dem die Isolierschicht-Seitenwand (24) dadurch hergestellt wird, dass eine Isolierschicht auf der gesamten Oberfläche des Substrats (10) einschließlich der Wortleitung (12) und der Deck-Isolierschicht (23) abgeschieden und anisotrop geätzt wird.

**41.** Verfahren zum Herstellen eines Halbleiter-Speicherbauteils nach Anspruch 40, bei dem die Abscheidungsdicke der Isolierschicht unter Berücksichtigung des Radius des Kontaktlochs kontrolliert wird.

**42.** Verfahren zum Herstellen eines Halbleiter-Speicherbauteils nach Anspruch 23, mit den folgenden Schritten:

- Herstellen, vor der dielektrischen Tunnelschicht (16), einer Feld-Isolierschicht (11) in einem Feldbereich in solcher Weise, dass in einer Richtung mit einem vorbestimmten Intervall mehrere aktive Bereiche auf dem Halbleitersubstrat (10) vom ersten Leitungstyp ausgebildet werden;
- Herstellen mehrerer Floatgates (13) mit einem vorbestimmten Intervall auf der dielektrischen Tunnelschicht (16) über dem aktiven Bereich;

- Herstellen der ferroelektrischen Dielektrikumsschicht (17) auf der gesamten Oberfläche des Substrats (10) einschließlich der Floatgates (13);
- Herstellen mehrerer Steuergates oder Wortleitungen (12) auf der ferroelektrischen Dielektrikumsschicht (17) in solcher Weise, dass eine Wortleitung (12) die Floatgates (13) rechtwinklig zu den aktiven Bereichen kontrolliert;
- abwechselndes Herstellen von Maskierungen zwischen den Wortleitungen (12);
- Herstellen der Ladungen-Eingangs/Ausgangs-Stufen (14) oder der Fremdstoffbereiche hoher Konzentration vom zweiten Leitungstyp auf den aktiven Bereichen unter Verwendung der Wortleitungen (12) und der Maskierungen als Maske;
- Abscheiden einer Zwischenschicht-Isolierschicht (18) auf der gesamten Oberfläche des Substrats (10) einschließlich der Wortleitungen (12) und Herstellen eines Kontaktlochs, um die Fremdstoffbereiche (14) hoher Konzentration vom zweiten Leitungstyp freizulegen; und
- Herstellen mehrerer Bitleitungen (15) auf der Zwischenschicht-Isolierschicht (18), so dass sie dadurch elektrisch mit den Fremdstoffbereichen (14) hoher Konzentration vom zweiten Leitungstyp verbunden sind.

**43.** Verfahren zum Herstellen eines Halbleiter-Speicherbauteils nach Anspruch 23, mit den folgenden Schritten:

- Herstellen, vor der dielektrischen Tunnelschicht (16), einer Feld-Isolierschicht (11) in einem Feldbereich in solcher Weise, dass in einer Richtung mit einem vorbestimmten Intervall mehrere aktive Bereiche auf dem Halbleitersubstrat (10) vom ersten Leitungstyp ausgebildet werden;
- Herstellen mehrerer Floatgates (13) mit einem vorbestimmten Intervall auf der dielektrischen Tunnelschicht (16) über dem aktiven Bereich;
- Herstellen der ferroelektrischen Dielektrikumsschicht (17) auf der gesamten Oberfläche des Substrats (10) einschließlich der Floatgates (13);
- Herstellen mehrerer Steuergates oder Wortleitungen (12) auf der ferroelektrischen Dielektrikumsschicht (17) in solcher Weise, dass eine Wortleitung (12) die Floatgates (13) rechtwinklig zu den aktiven Bereichen kontrolliert;
- abwechselndes Herstellen von Maskierungen zwischen den Wortleitungen (12);
- Herstellen der Ladungen-Eingangs/Ausgangs-Stufen (14) oder der Fremdstoffbereiche hoher Konzentration vom zweiten Leitungstyp auf den aktiven Bereichen unter Verwendung der Wortleitungen (12) und der Maskierungen als Maske;
- selektives Entfernen der ferroelektrischen Dielektrikumsschicht (17) und der dielektrischen Tunnelschicht (16) unter Verwendung der Wortleitungen (12) und Maskierungen als Maske;
- Herstellen einer Isolierschicht-Seitenwand (23) auf der Seite der Wortleitungen (12) und der Deck-Isolierschicht (23), um dadurch ein Kontaktloch auf den Fremdstoffbereichen (14) auszubilden; und
- Herstellen mehrerer Bitleitungen (15), die dadurch elektrisch mit den Fremdstoffbereichen (14) verbunden sind.

**44.** Verfahren zum Herstellen eines Halbleiter-Speicherbauteils nach Anspruch 43, bei dem die Maskierung, die Isolierschicht-Seitenwand (23), die ferroelektrische Dielektrikumsschicht (17) oder die dielektrische Tunnelschicht (16) aus einem Material mit großem wechselseitigem Selektionsverhältnis hergestellt wird.

## Revendications

**1.** Dispositif de mémoire à semi-conducteur comprenant au moins :

- un substrat de semi-conducteur de premier type de conductivité (10) ;
- une première électrode de grille flottante (13) formée sur une couche diélectrique (16) sur ledit substrat de semi-conducteur (10) pour charger/décharger des charges ;
- une seconde électrode de grille flottante (12) formée sur une couche ferroélectrique (17) au-dessus de ladite première électrode pour entourer ladite première électrode placée au-dessous afin de contrôler le chargement/déchargement et la lecture/écriture de données de ladite première électrode (13) ; et
- un étage d'entrée/sortie de charge (14) formé sur ledit substrat de semi-conducteur (10) au moins sur un côté de ladite seconde électrode (12) pour fournir lesdites charges, dans lequel ledit étage d'entrée/sortie de charge (14) et ladite seconde électrode (12) se chevauchent pour former un troisième condensateur.

**2.** Dispositif de mémoire à semi-conducteur selon la revendication 1, dans lequel ledit étage d'entrés/sortie de charge (14) est formé sur ledit substrat (10) des deux côtés de ladite seconde électrode (12).

**3.** Dispositif de mémoire à semi-conducteur selon la revendication 1, dans lequel une région d'impureté est formée sur ledit substrat (10) des deux côtés de ladite seconde électrode (12) pour former ledit étage d'entrée/sortie de charge (14).

**4.** Dispositif de mémoire à semi-conducteur selon la revendication 1, 2 ou 3, dans lequel des lignes de bits (15) sont couplées à ledit étage d'entrée/sortie de charge (14).

**5.** Dispositif de mémoire à semi-conducteur selon la revendication 1, 2, 3 ou 4, dans lequel ledit substrat de semi-conducteur (10) est de type P, et ledit étage d'entrée/sortie de charge (14) est de type N de grande concentration.

**6.** Dispositif de mémoire à semi-conducteur selon la revendication 1, dans lequel

le substrat de semi-conducteur de premier type de conductivité (10) est utilisé au titre d'une électrode d'un premier condensateur ;

la première électrode (13) formée sur ledit substrat de semi-conducteur (10) est utilisée au titre de l'autre électrode dudit premier condensateur et au titre d'une électrode d'un second condensateur ;

la seconde électrode (12) formée sur ladite première électrode (13) est utilisée au titre de l'autre électrode dudit second condensateur ; et

l'étage d'entrée/sortie de charge (14) est formé sur ledit substrat de semi-conducteur (10) sur un côté de ladite seconde électrode (12) pour fournir des charges à accumuler dans ladite première électrode (13).

**7.** Dispositif de mémoire à semi-conducteur selon la revendication 6, dans lequel ledit étage d'entrée/sortie de charge (14) est de second type de conductivité de grande concentration.

**8.** Dispositif de mémoire à semi-conducteur selon la revendication 6, dans lequel ledit étage d'entrée/sortie de charge (14) est de type N de grande concentration.

**9.** Dispositif de mémoire à semi-conducteur selon l'une quelconque des revendications 1 à 8, comprenant au moins une cellule d'unité formée sous la forme d'un condensateur MOS de grille à empilage dans laquelle la première électrode (13) ou la grille flottante et la seconde électrode (12) ou la grille de contrôle sont empilées sur le substrat (10), et la région d'impureté utilisée au titre d'un étage d'entrée/sortie de charge (14) est formée sur ledit substrat (10) et placée sur un côté de ladite grille de contrôle (12).

**10.** Dispositif de mémoire à semi-conducteur selon la revendication 9, comprenant :

une pluralité de condensateurs MOS de grille à empilage (Cmn) disposée sous la forme d'une matrice;
une pluralité de lignes de mots (WL) pour contrôler la même rangée de condensateurs MOS de grille à empilage (Cmm) en même temps ;
une pluralité de lignes de bits (BL) pour écrire et lire des données dans la même colonne de condensateurs MOS de grille à empilage (Cmn) ; et
une pluralité d'amplificateurs de détection (SA) pour détecter et délivrer des données à partir desdites lignes de bits (BL).

**11.** Dispositif de mémoire à semi-conducteur selon la revendication 10, dans lequel les grilles de contrôle (12) de la même rangée de condensateurs MOS de grille à empilage sont connectés à une ligne de mot (WL) unique, les étages d'entrée/sortie de charge (14) de la même colonne de condensateurs MOS de grille à empilage sont connectées à une ligne de bit (BL) unique et lesdits amplificateurs de détection (SA) prennent les lignes de bits (BL) correspondantes au titre de leur port d'entrée et reçoivent une tension de référence (Vref) par l'intermédiaire de leur autre port d'entrée.

**12.** Dispositif de mémoire à serai-conducteur selon la revendication 1, dans lequel sur le substrat de semi-conducteur de premier type de conductivité (10), une première couche d'isolation (11) est formée de sorte qu'une pluralité de régions actives soit formée dans une direction à un intervalle prédéterminé ;

une pluralité de secondes électrodes (12) est formée au titre de lignes de mots au-dessus dudit substrat de semi-conducteur (10) à un intervalle prédéterminé, perpendiculaire aux dites régions actives ;

une pluralité de premières électrodes (13) est formée au titre de grilles flottantes entre lesdites lignes de mots (12) et le substrat de semi-conducteur (10) dans les régions actives ;

les étages d'entrée/sortie de charge (14) sont formés sur les régions actives entre lesdites lignes de mots (12) ; et

une pluralité de lignes de bits (15) est formée sur lesdites lignes de mots (12) au-dessus desdites régions actives, perpendiculaires aux dites lignes de mots (12).

**13.** Dispositif de mémoire à semi-conducteur selon la revendication 12, dans lequel ledit étage d'entrée/sortie de charge (14) est formé sur les régions actives placées entre deux lignes de mots (12).

**14.** Dispositif de mémoire à semi-conducteur selon la revendication 12, dans lequel, ledit étage d'entrée/sortie de charge (14) est de second type de conductivité de grande concentration.

**15.** Dispositif de mémoire à semi-conducteur selon la revendication 12, dans lequel lesdites étages d'entrée/sortie de charge (14) formés sur la même région active sont couplées à une ligne de bit (15) unique.

**16.** Dispositif de mémoire à semi-conducteur selon la revendication 1, dans lequel sur le substrat de semi-conducteur de premier type de conductivité (10), une couche d'isolation de champ (11) est formée dans une région de champ de sorte qu'une pluralité de régions actives soit formée dans une direction à un intervalle prédéterminé ;

une pluralité de étages d'entrée/sortie de charge (14) est formée sur ledit substrat de semi-conducteur (10) dans lesdites régions actives à un intervalle prédéterminé ;

une couche diélectrique de tunnelage (16) est formée sur ledit substrat de semi-conducteur (10), ladite couche (16) ayant un trou de contact dans ledit étage d'entrée/sortie de charge (14) ;

une pluralité de premières électrodes ou de grilles flottantes (13) est formée en matrice sur ladite couche diélectrique de tunnelage (16) au-dessus desdites régions actives entre lesdites étages d'entrée/sortie de charge (14) ;

une couche ferroélectrique (17) est formée sur la surface d'ensemble dudit substrat (10) comprenant lesdites grilles flottantes (13), ladite couche (17) ayant un trou de contact dans ledit étage d'entrée/sortie de charge (14) ;

une pluralité de secondes électrodes ou lignes de mots (12) est formée sur ladite couche ferroélectrique (17) au-dessus desdites grilles flottantes (13) perpendiculaires aux dites régions actives ;

une couche d'isolation inter-niveau (18) est formée sur la surface d'ensemble dudit substrat (10) comprenant lesdites lignes de mots (12), ladite couche (18) ayant un trou de contact dans ledit étage d'entrée/sortie de charge (14) ; et

une pluralité de lignes de bits (15) est formée sur ladite couche d'isolation inter-niveau (18) pour ainsi connecter de manière électrique lesdites étages d'entrés/sortie de charge (14) formés sur la même région active.

**17.** Dispositif de mémoire à semi-conducteur selon la revendication 16, dans lequel deux grilles flottantes sont formées sur ladite couche diélectrique de tunnelage (16) au-dessus des régions actives placées entre lesdites étages d'entrée/sortie de charge (14).

**18.** Dispositif de mémoire à semi-conducteur selon la revendication 16, dans lequel ladite couche diélectrique de tunnelage (16), la couche ferroélectrique (17) et la couche d'isolation inter-niveau (18) sont formées pour avoir un trou de contact dans un étage d'entrée/sortie de charge (14) sur deux.

**19.** Dispositif de mémoire à semi-conducteur selon la revendication 16, dans lequel ladite couche diélectrique de tunnelage (16) est formée en PZT.

**20.** Dispositif de mémoire à semi-conducteur selon la revendication 16, dans lequel lesdites lignes de mots (12) sont formées pour entourer les grilles flottantes respectives (13).

**21.** Dispositif de mémoire à semi-conducteur selon la revendication 16, dans lequel ladite couche diélectrique de tunnelage (16) est formée d'une épaisseur de 7 à 15 nm.

**22.** Dispositif de mémoire à semi-conducteur selon la revendication 16, dans lequel ladite couche ferroélectrique (17) est formée dans une couche d'oxyde, un empilage d'oxyde/nitrite ou d'oxyde/nitrite/oxyde, ou de PZT.

**23.** Procédé de fabrication de dispositif de mémoire à semi-conducteur, comprenant les étapes consistant à :

- former une couche diélectrique de tunnelage (16) sur un substrat de semi-conducteur (10) ;
- former une grille flottante (13) sur ladite couche diélectrique de tunnelage (16) ;

- former une couche ferroélectrique (17) sur la surface d'ensemble dudit substrat (10) comprenant ladite grille flottante (13) ;
- former une grille de contrôle (12) sur ladite couche ferroélectrique (17) au-dessus de ladite grille flottante (13) pour entourer la grille flottante (13) placée au-dessous ; et
- former un étage d'entrée/sortie de charge (14) sur au moins un côté de ladite grille de contrôle (12) pour former un troisième condensateur.

**24.** Procédé de fabrication d'un dispositif de mémoire à semi-conducteur selon la revendication 23, dans lequel ledit étage d'entrée/sortie de charge (14) est formé des deux côtés de ladite grille de contrôle (12).

**25.** Procédé de fabrication d'un dispositif de mémoire à semi-conducteur selon la revendication 23, dans lequel ledit étage d'entrée/sortie de charge (14) est formé en implantant des ions d'impuretés de type N de grande concentration, en utilisant ladite grille de contrôle (12) en tant que masque.

**26.** Procédé de fabrication d'un dispositif de mémoire à serai-conducteur selon la revendication 23, dans lequel ladite grille flottante (13) est formée en polysilicium ou en métal.

**27.** Procédé de fabrication d'un dispositif de mémoire à semi-conducteur selon la revendication 23, dans lequel ladite grille de contrôle (12) est formée en polysilicium ou en métal.

**28.** Procédé de fabrication d'un dispositif de mémoire à semi-conducteur selon la revendication 23, dans lequel ladite couche diélectrique de tunnelage (16) est formée par dépôt de PZT.

**29.** Procédé de fabrication d'un dispositif de mémoire à semi-conducteur selon la revendication 23, dans lequel ladite couche diélectrique de tunnelage (16) est formée d'une épaisseur de 7 à 15 nm.

**30.** Procédé de fabrication d'un dispositif de mémoire à semi-conducteur selon la revendication 23, dans lequel ladite couche diélectrique ferroélectrique (17) est formée d'une couche d'oxyde ou d'un empilage d'oxyde/nitrite.

**31.** Procédé de fabrication d'un dispositif de mémoire à semi-conducteur selon la revendication 23, dans lequel ladite couche diélectrique ferroélectrique (17) est formée d'une couche d'oxyde ou d'un empilage d'oxyde/nitrite/oxyde.

**32.** Procédé de fabrication d'un dispositif de mémoire à semi-conducteur selon la revendication 23, dans lequel ladite couche diélectrique ferroélectrique (17) est formée par dépôt de PZT.

**33.** Procédé de fabrication d'un dispositif de mémoire à semi-conducteur selon la revendication 23, comprenant les étapes consistant à :

former avant la couche diélectrique de tunnelage (16) une couche d'isolation de champ (11) dans une région de champ de sorte qu'une pluralité de régions actives soit formée dans une direction à un intervalle prédéterminé sur le substrat de semi-conducteur de premier type de conductivité (10) ;
former une pluralité de grilles flottantes (13) sur ladite couche diélectrique de tunnelage (16) au-dessus desdites régions actives à un intervalle prédéterminé ;
former la couche diélectrique ferroélectrique (17) sur la surface d'ensemble dudit substrat (10) comprenant ladite pluralité de grilles flottantes (13) ;
former une pluralité de grilles de contrôle ou de lignes de mots (12) sur ladite couche diélectrique ferroélectrique (17) de sorte qu'une ligne de mots (12) contrôle lesdites grilles flottantes (13) perpendiculaires aux dites régions actives ;
former les étages d'entrée/sortie de charge (14) ou les régions d'impuretés de second type de conductivité de grande concentration dans lesdites régions actives entre lesdites lignes de mots (12) ;
déposéer une couche d'isolation inter-niveau (18) sur la surface d'ensemble dudit substrat (10) comprenant lesdites lignes de mots (12) ; et
former un trou de contact de sorte que des régions d'impuretés de second type de conductivité de grande concentration (14) soient exposées ; et former une pluralité de lignes de bits (15) sur ladite couche d'isolation inter-niveau (18) pour être ainsi couplée de manière électrique aux dites régions d'impuretés de second type de conductivité de grande concentration (14).

**34.** Procédé de fabrication d'un dispositif de mémoire à semi-conducteur selon la revendication 33, dans lequel ledit trou de contact est formé pour chaque région d'impuretés de grande concentration (14).

**35.** Procédé de fabrication d'un dispositif de mémoire à semi-conducteur selon la revendication 36, dans lequel ledit substrat de semi-conducteur (10) utilise un type P et ladite région d'impuretés (14) est formé en tant que type N.

**36.** Procédé de fabrication d'un dispositif de mémoire à semi-conducteur selon la revendication 33, dans lequel lesdites lignes de mots (12) sont formées pour entourer lesdites grille flottantes (13) qui sont placés sous celles-ci.

**37.** Procédé de fabrication d'un dispositif de mémoire à semi-conducteur selon la revendication 23, comprenant les étapes consistant à :

former avant la couche diélectrique de tunnelage (16) une couche d'isolation de champ (11) dans une région de champ de sorte qu'une pluralité de régions actives soit formée dans une direction à un intervalle prédéterminé sur le substrat de semi-conducteur de premier type de conductivité (10) ;
former une pluralité de grilles flottantes (13) sur ladite couche diélectrique de tunnelage (16) au-dessus desdites régions actives à un intervalle prédéterminé;
former une couche diélectrique ferroélectrique (17) sur la surface d'ensemble dudit substrat (10) comprenant ladite pluralité de grilles flottantes (13) ;
former une pluralité de grilles de contrôle ou de lignes de mots (12) empilées par une couche d'isolation de capuchon (23) sur ladite couche diélectrique ferroélectrique (17) de sorte qu'une ligne de mot (12) contrôle lesdites grilles flottantes (13) perpendiculaires aux dites régions actives ;
former les étages d'entrée/sortie de charge (14) ou les régions d'impuretés sur lesdites régions actives entre lesdites lignes de mots (12) ;
enlever sélectivement ladite couche diélectrique ferroélectrique (17) et ladite couche diélectrique de tunnelage (16) en utilisant lesdites lignes de mots (12) en tant que masque ;
former une paroi latérale de couche d'isolation (24) sur la surface latérale desdites lignes de mots (12) et des couches d'isolation de capuchon (23) pour former ainsi un trou de contact sur lesdites régions d'impuretés (14) ; et
former une pluralité de lignes de bits (15) pour qu'elle soit électriquement couplée aux dites régions d'impuretés (14).

**38.** Procédé de fabrication d'un dispositif de mémoire à serai-conducteur selon la revendication 37, dans lequel ladite étape consistant à former les lignes de mots est effectuée de sorte qu'une couche conductrice et qu'une couche d'isolation soient enlevées de manière séquentielle sur ladite couche diélectrique ferroélectrique (17) et sélectivement enlevées par photo lithographie et par gravure, en formant ainsi une ligne de mots (12) au-dessus desdites grilles flottantes (13) perpendiculaires aux dites régions actives.

**39.** Procédé de fabrication d'un dispositif de mémoire à semi-conducteur selon la revendication 37, dans lequel ladite couche d'isolation de capuchon (23) est formée d'un matériau ayant un grand taux de sélection de gravure entre ladite couche diélectrique de tunnelage (16) et ladite couche diélectrique ferroélectrique (17).

**40.** Procédé de fabrication d'un dispositif de mémoire à semi-conducteur selon la revendication 37, dans lequel ladite paroi latérale de couche d'isolation (24) est formée déposant et en gravant de manière anisotropique une couche d'isolation sur la surface d'ensemble dudit substrat (10) comprenant ladite ligne de mots (12) et ladite couche d'isolation de capuchon (23).

**41.** Procédé de fabrication d'un dispositif de mémoire à semi-conducteur selon la revendication 40, dans lequel l'épaisseur de dépôt de ladite couche d'isolation est contrôlée par rapport au rayon dudit trou de contact.

**42.** Procédé de fabrication de dispositif de mémoire à semi-conducteur selon la revendication 23 comprenant les étapes consistant à :

former avant la couche diélectrique de tunnelage (16) une couche d'isolation de champ (11) dans une région de champ de sorte qu'une pluralité de régions actives soit formée dans une direction à un intervalle prédéterminé sur le substrat de semi-conducteur de premier type de conductivité (10) ;
former une pluralité de grilles flottantes (13) sur ladite couche diélectrique de tunnelage (16) au-dessus desdites régions actives à un intervalle prédéterminé ;
former une couche diélectrique ferroélectrique (17) sur la surface d'ensemble dudit substrat (10) comprenant ladite pluralité de grilles flottantes (13) ;
former une pluralité de grilles de contrôle ou de lignes de mots (12) sur ladite couche diélectrique ferroélectrique (17) de sorte qu'une ligne de mot (12) contrôle lesdites grilles flottantes (13) perpendiculaires aux dites régions actives ;
en variante, former des masques entre lesdites lignes de mots (12) ;
former les étages d'entrée/sortie de charge (14) ou les régions d'impuretés de second type de conductivité de grande concentration sur lesdites régions actives en utilisant lesdites lignes de mots (12) et des masques au titre d'un masque ;
déposer une couche d'isolation inter-niveau (18) sur la surface d'ensemble dudit substrat (10) comprenant lesdites lignes de mots (12), et former un trou de contact pour exposer lesdites régions d'impuretés de second type de conductivité de grande concentration (14) ; et
former une pluralité de lignes de bits (15) sur ladite couche d'isolation inter-niveau (18) pour qu'elle soit électriquement couplée aux dites régions d'impuretés de second type de conductivité de grande concentration (14).

**43.** Procédé de fabrication d'un dispositif de mémoire à semi-conducteur selon la revendication 23 comprenant les étapes consistant à :

former avant la couche diélectrique de tunnelage (16) une couche d'isolation de champ (11) dans une région de champ de sorte qu'une pluralité de régions actives soit formée dans une direction à un intervalle prédéterminé sur le substrat de semi-conducteur de premier type de conductivité (10) ;
former une pluralité de grilles flottantes (13) sur ladite couche diélectrique de tunnelage (16) au-dessus desdites régions actives à un intervalle prédéterminé ;
former une couche diélectrique ferroélectrique (17) sur la surface d'ensemble dudit substrat (10) comprenant ladite pluralité de grilles flottantes (13) ;
former une pluralité de grilles de contrôle ou de lignes de mots (12) empilées par une couche d'isolation de capuchon (23) sur ladite couche diélectrique ferroélectrique (17) de sorte qu'une ligne de mot (12) contrôle lesdites grilles flottantes (13) perpendiculaires aux dites régions actives ;
en variante, former des masques entre lesdites lignes de mots (12) ;
former les étages d'entrée/sortie de charge (14) ou les régions d'impuretés de second type de conductivité de grande concentration sur lesdites régions actives en utilisant lesdites lignes de mots (12) et des masques au titre d'un masque ;
enlever sélectivement ladite couche diélectrique ferroélectrique (17) et la couche diélectrique de tunnelage (16) en utilisant lesdites lignes de mots (12) et des masques au titre d'un masque ;
former une paroi latérale de couche d'isolation (23) sur le côté desdites lignes de mots (12) et une couche d'isolation de capuchon (23) pour former ainsi un trou de contact sur lesdites régions d'impuretés (14) ; et
former une pluralité de lignes de bits (15) pour qu'elle soit électriquement couplée aux dites régions d'impuretés (14).

**44.** Procédé de fabrication d'un dispositif de mémoire à semi-conducteur selon la revendication 43, dans lequel ledit masque, ladite paroi latérale de couche d'isolation (23), ladite couche diélectrique ferroélectrique (17) ou la couche d'isolation de tunnelage (16) est formée d'un matériau ayant un grand taux de sélection de gravure entre ceux-ci.

F.I G.1
prior art

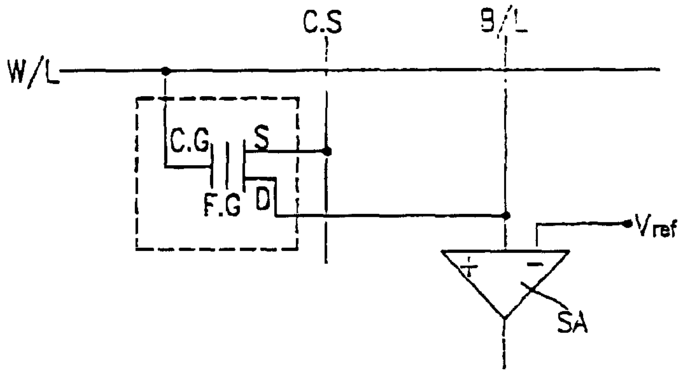


F.I G.2
prior art

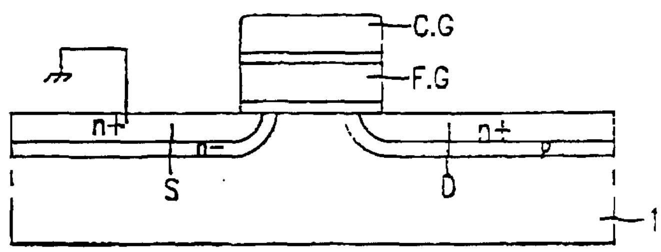

F. I G.3
prior art

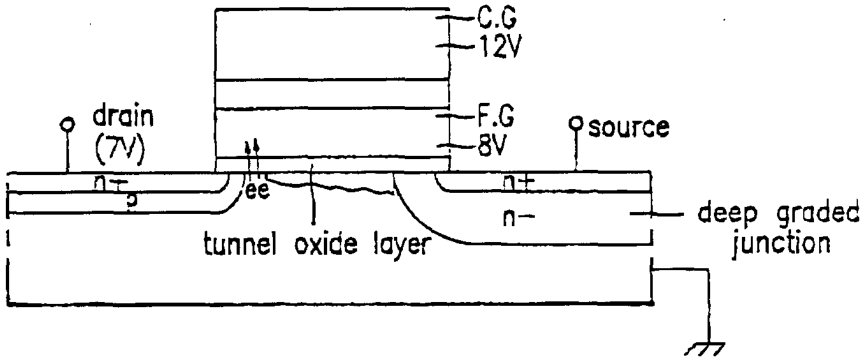


F. I G.4
prior art

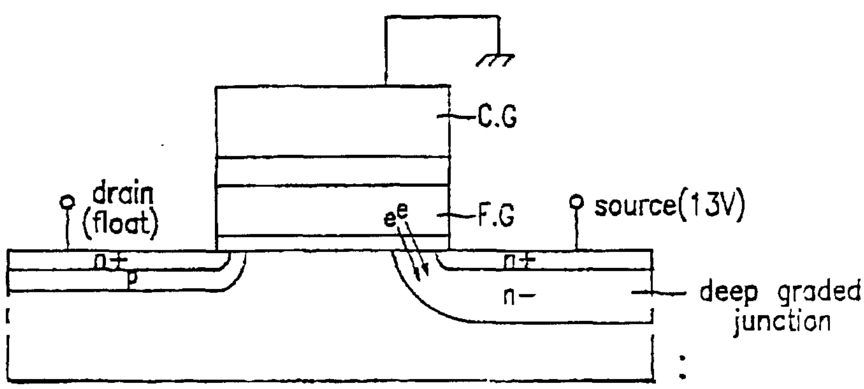

F I G.5a

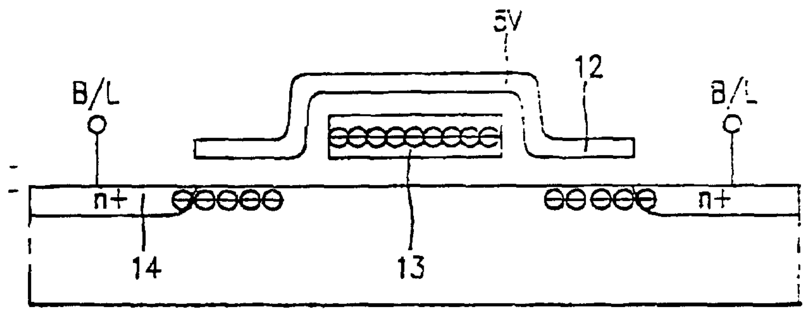


F I G.5b

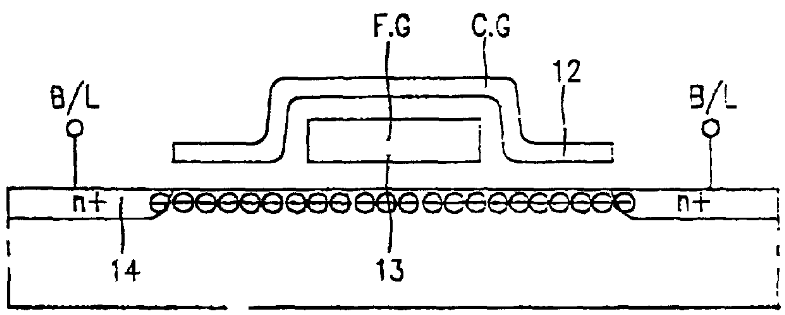

F I G.6

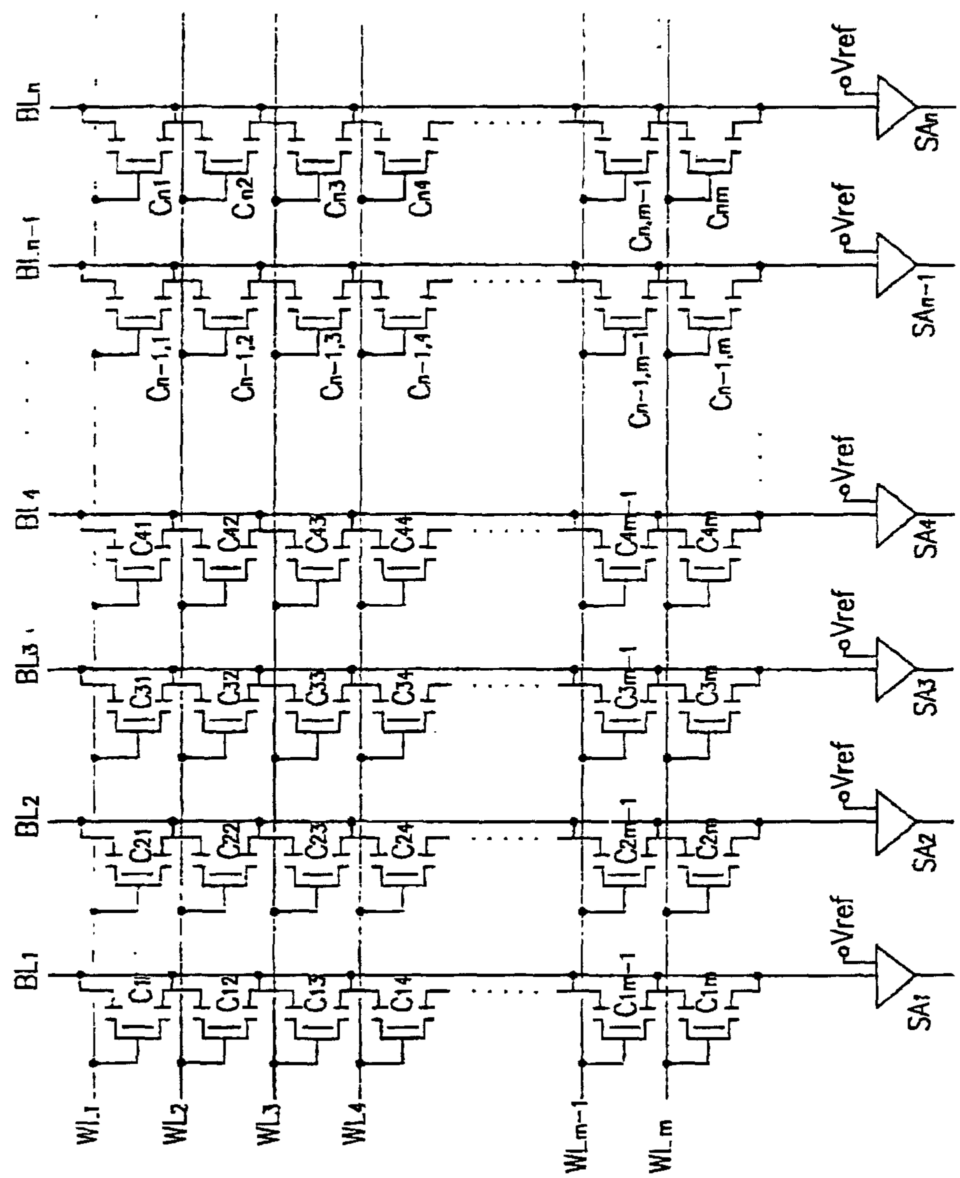
BL1
BL2
BL3
BL4
BLn-1
BLn
WL1
WL2
WL3
WL4
WLm-1
WLm
C11
C12
C13
C14
C1m-1
C1m
C21
C22
C23
C24
C2m-1
C2m
C31
C32
C33
C34
C3m-1
C3m
C41
C42
C43
C44
C4m-1
C4m
Cn-1,1
Cn-1,2
Cn-1,3
Cn-1,4
Cn-1,m-1
Cn-1,m
Cn1
Cn2
Cn3
Cn4
Cn,m-1
Cnm
Vref
SA1
SA2
SA3
SA4
SAn-1
SAn

F I G.7

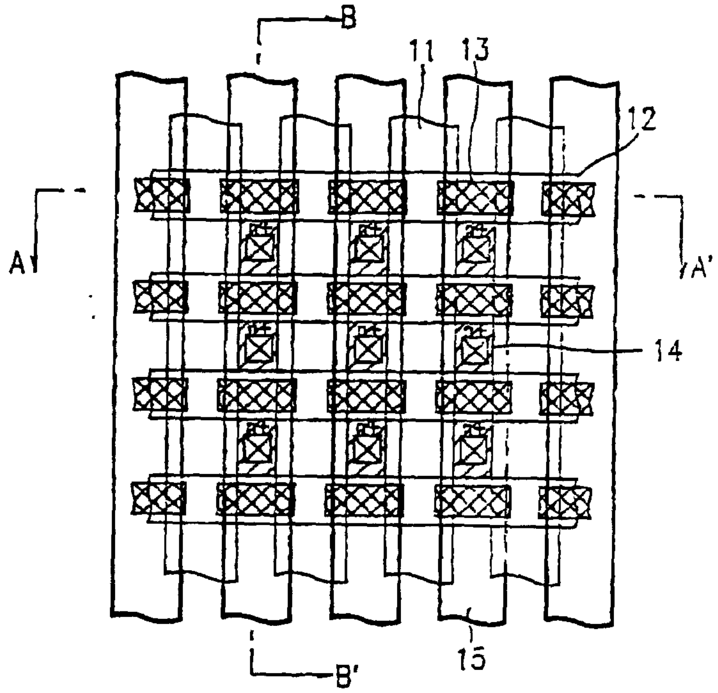

F I G.8

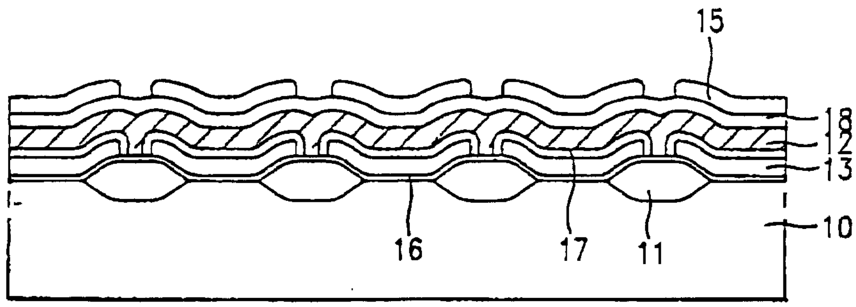


F I G.9

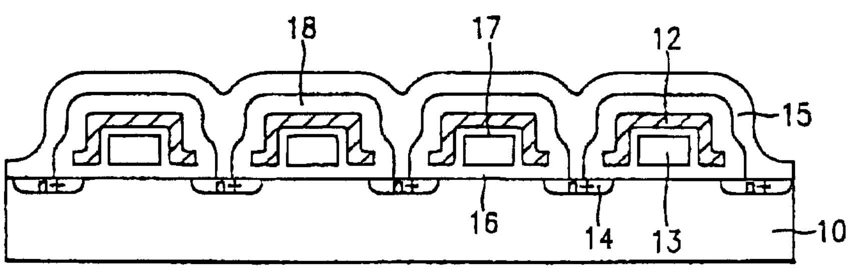

F I G.10a

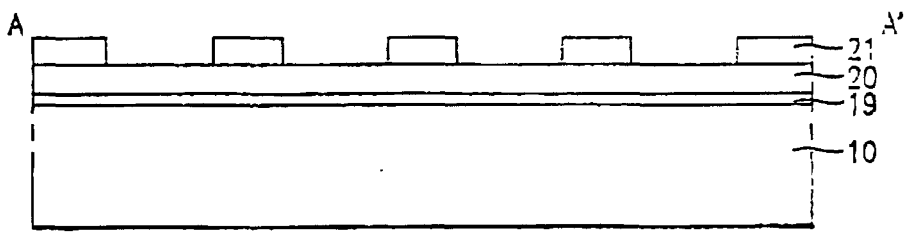


F I G.10b

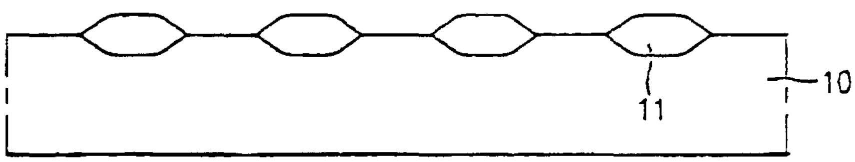


F I G.10c

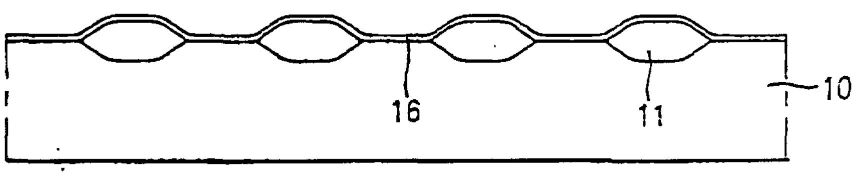


F I G.10d

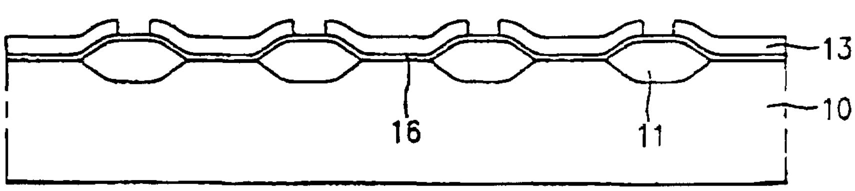


F I G.10e

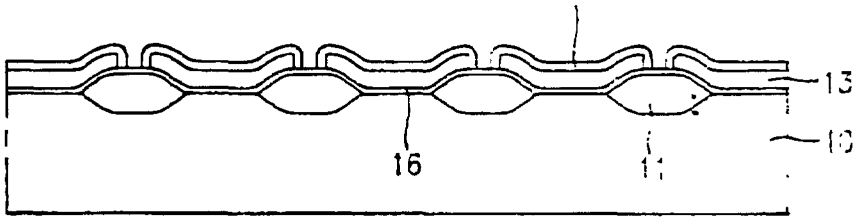

F I G.10f

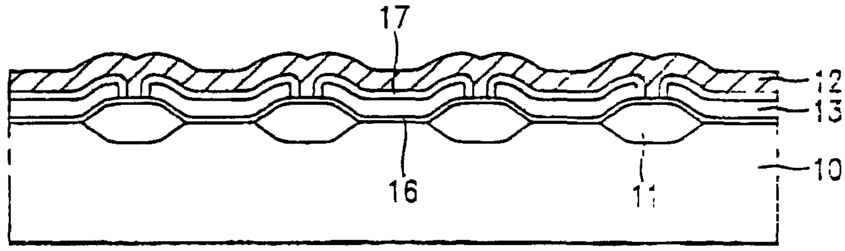


F I G.10g

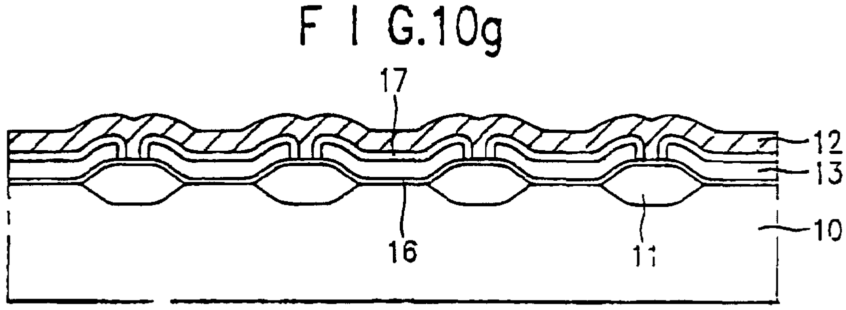


F I G.10h

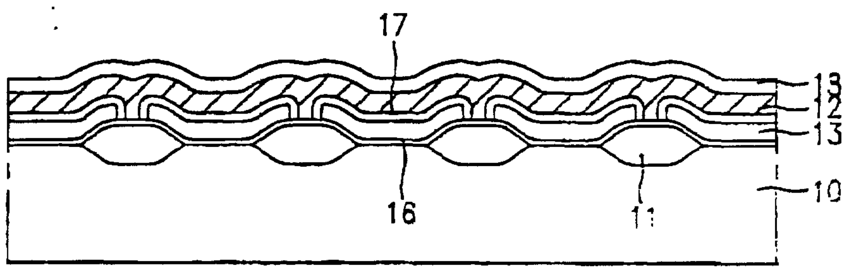


F I G.10i

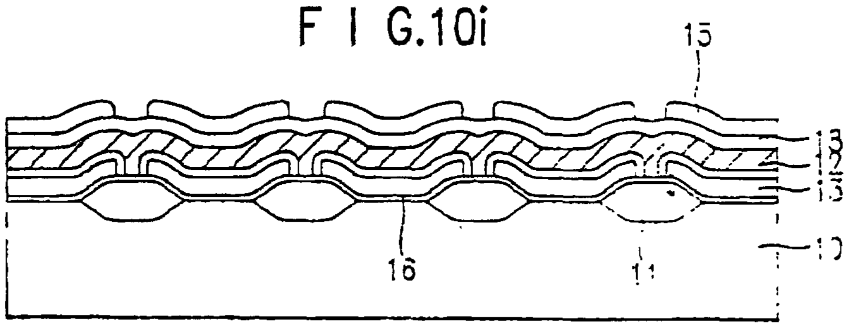

F I G.11a

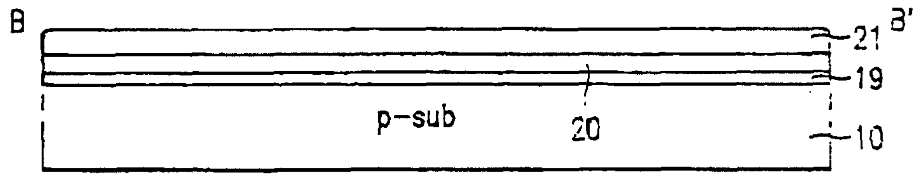


F I G.11b

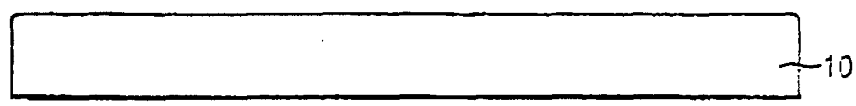


F I G.11c

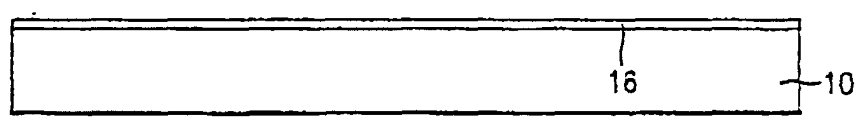


F I G.11d

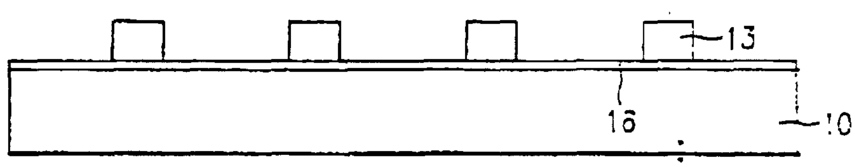

F I G.11e

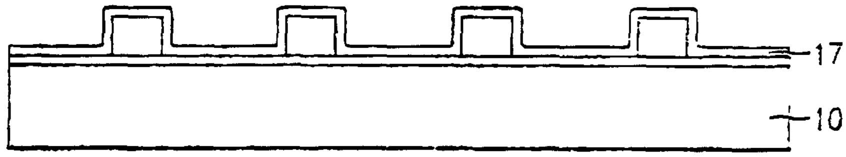


F I G.11f

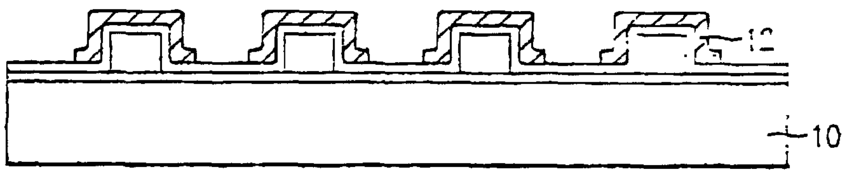


F I G.11g

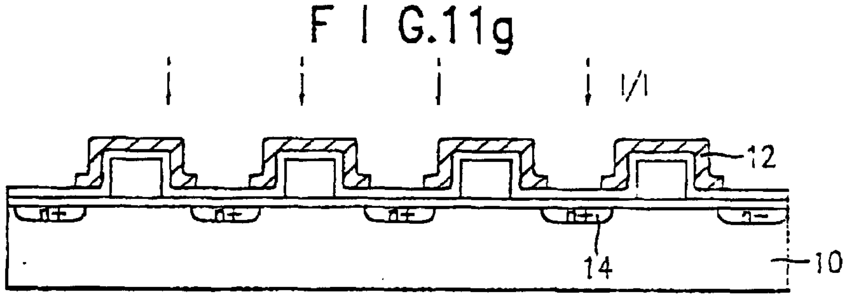


F I G.11h

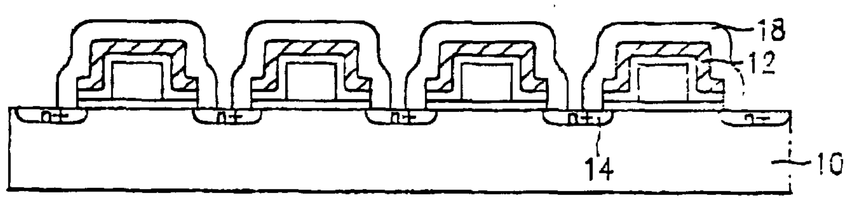


F I G.11i

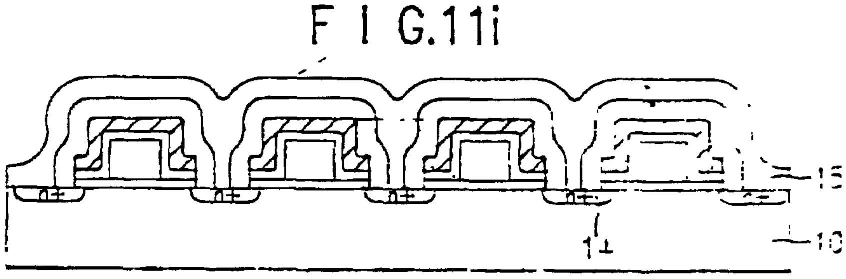

F I G.12a

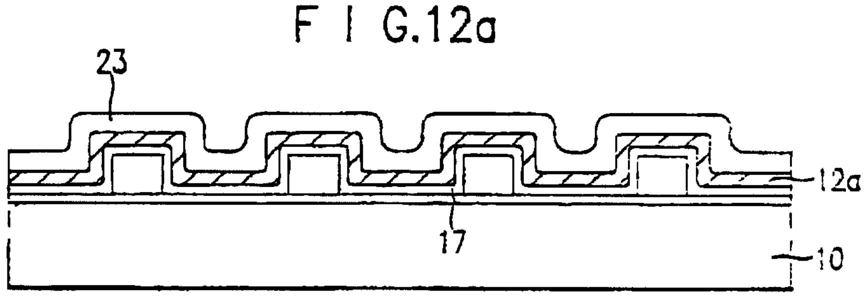


F I G.12b

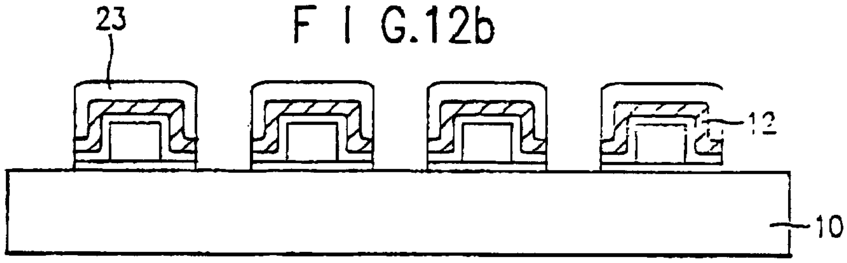


F I G.12c

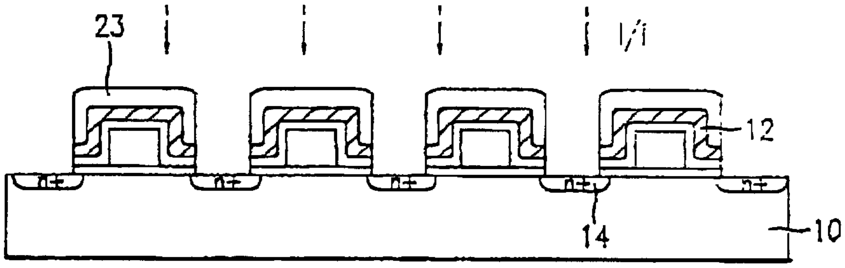


F I G.12d

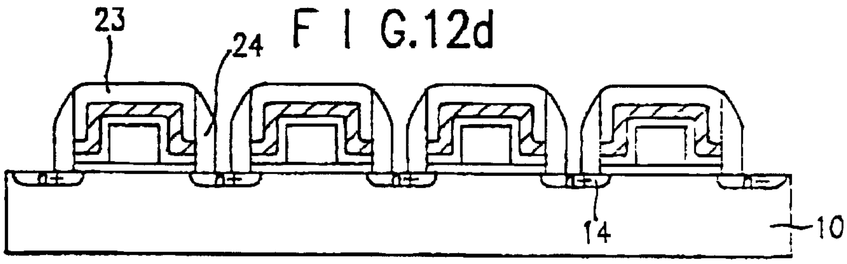


F I G.12e

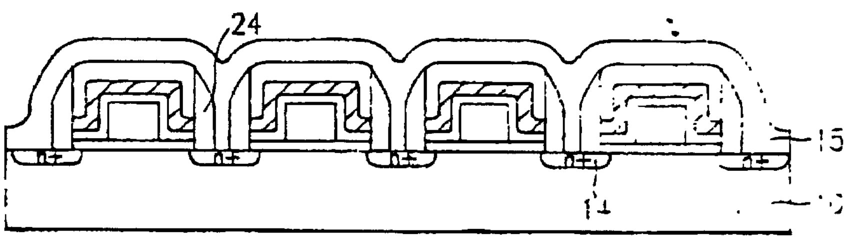

F I G.13

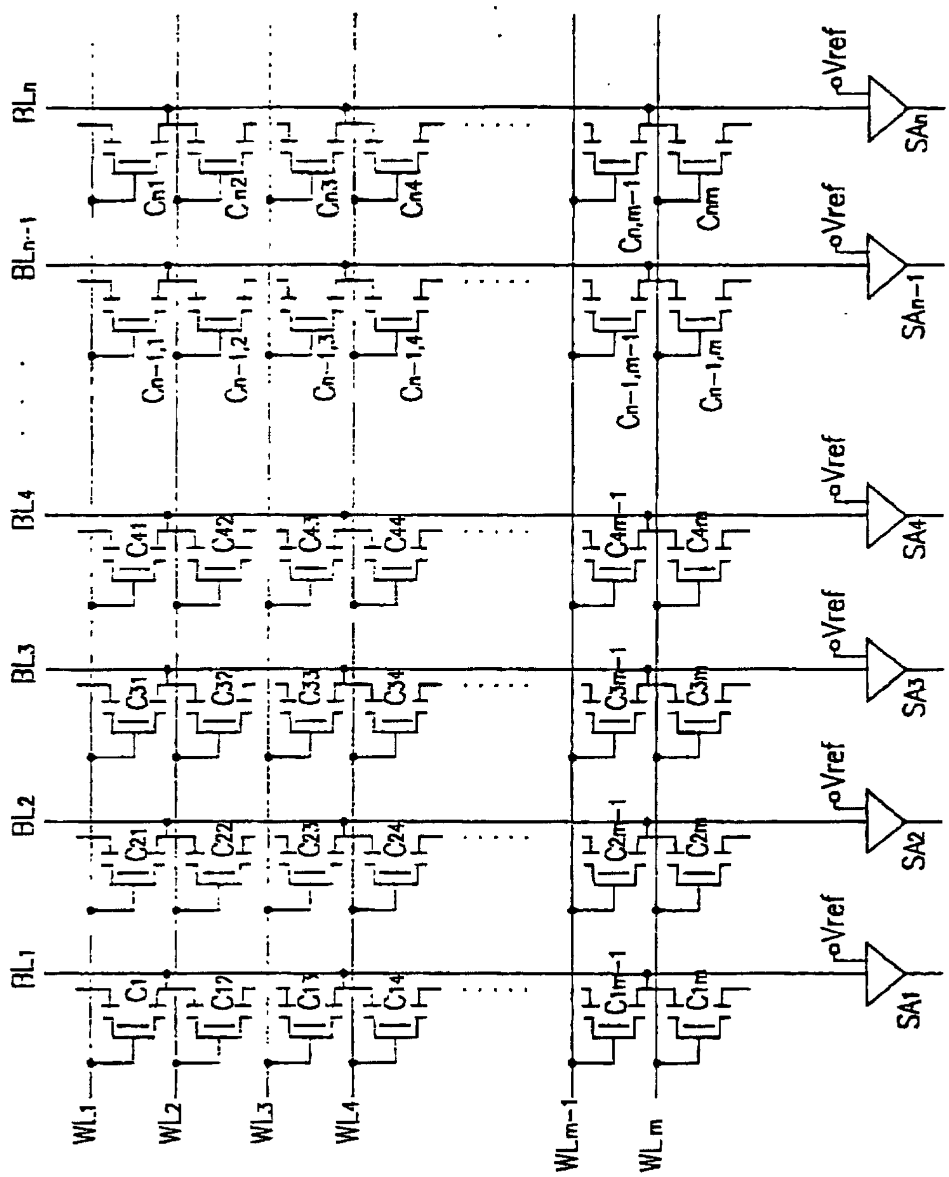
BL1
BL2
BL3
BL4
BLn-1
BLn
WL1
WL2
WL3
WL4
WLm-1
WLm
SA1
SA2
SA3
SA4
SAn-1
SAn
Vref

F I G.14

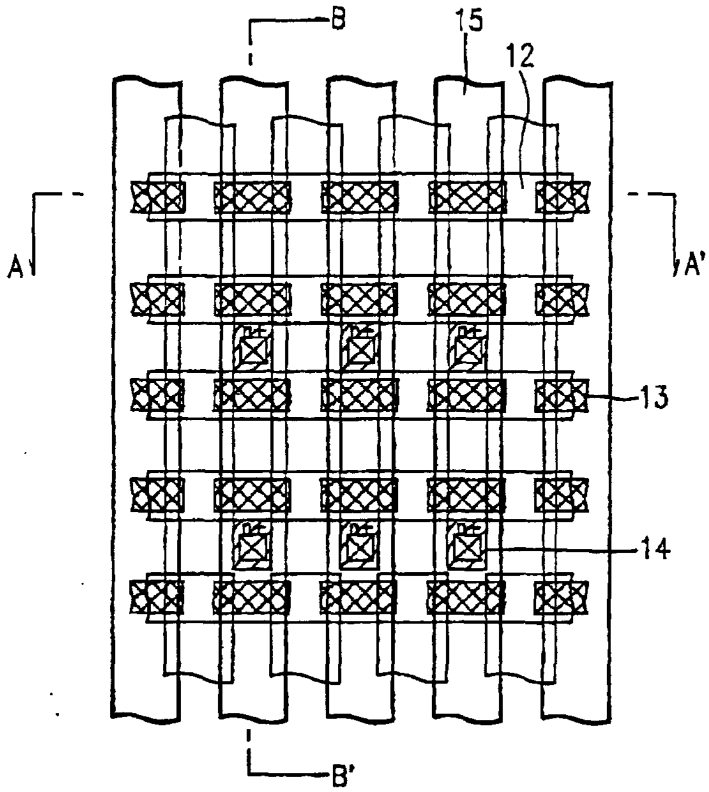


F I G.15

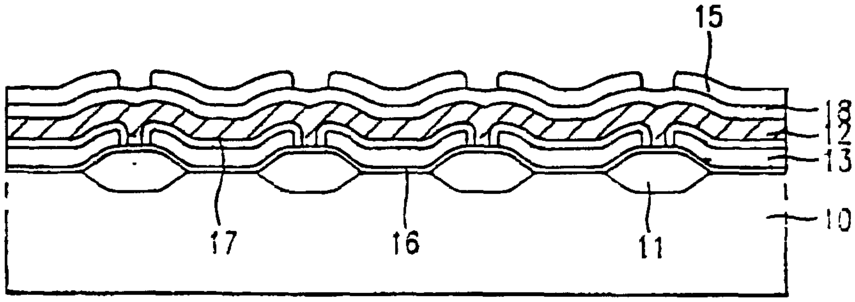

FIG. 16

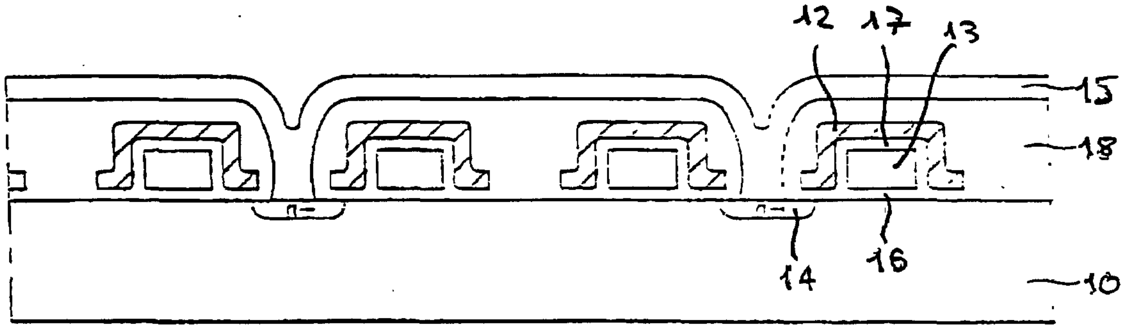

F I G.17a

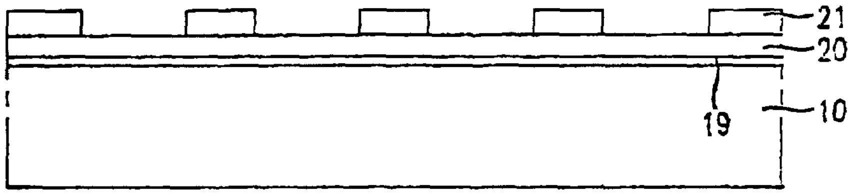


F I G.17b

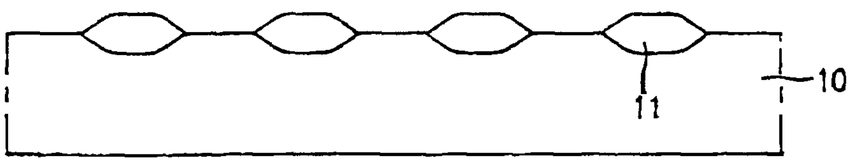


F I G.17c

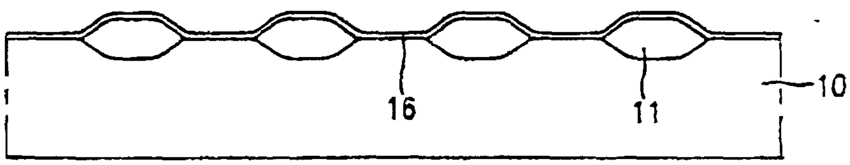


F I G.17d

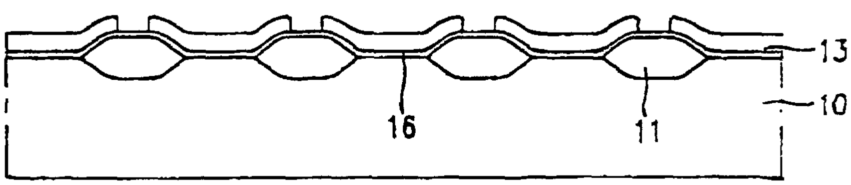


F I G.17e

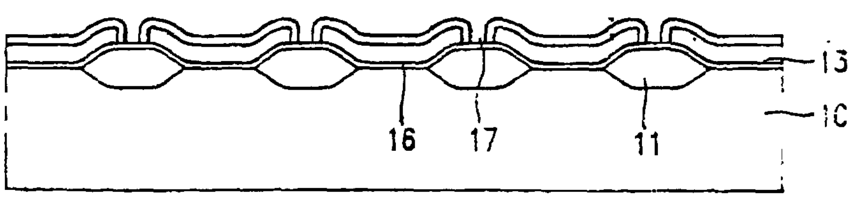

F I G.17f

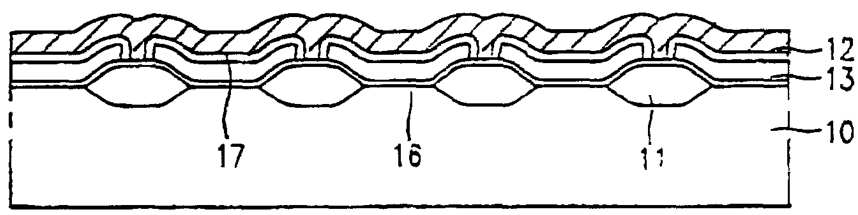


F I G.17g

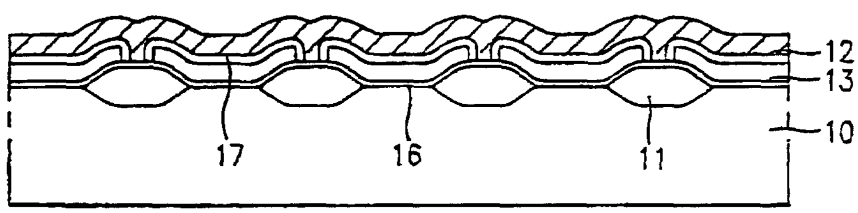


F I G.17h

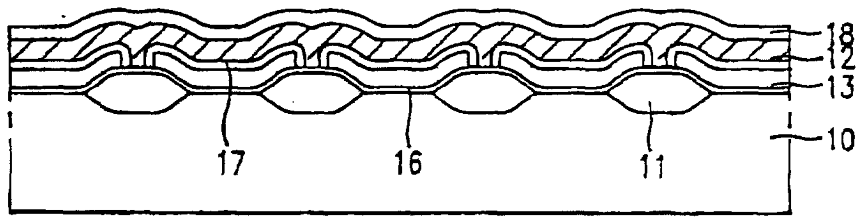


F I G.17i

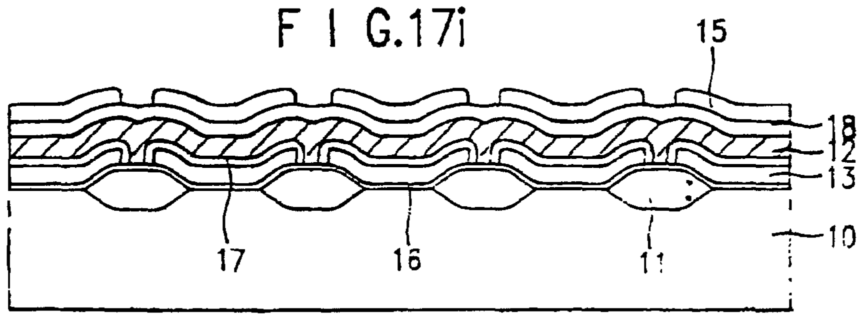

F I G.18a

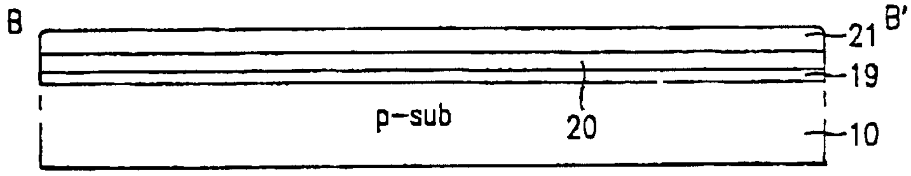


F I G.18b

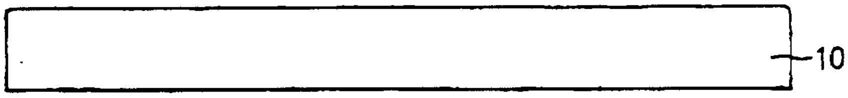


F I G.18c

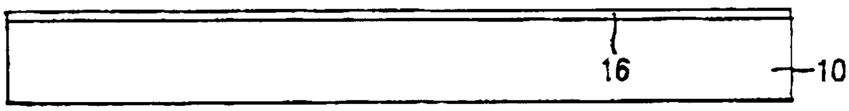


F I G.18d

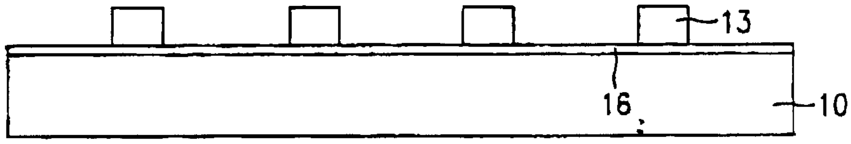

F I G.18e

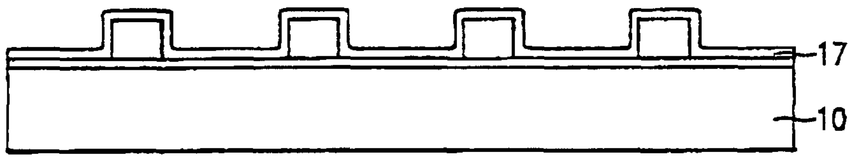


F I G.18f

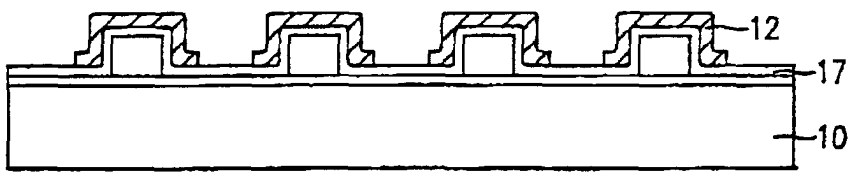


F I G.18g

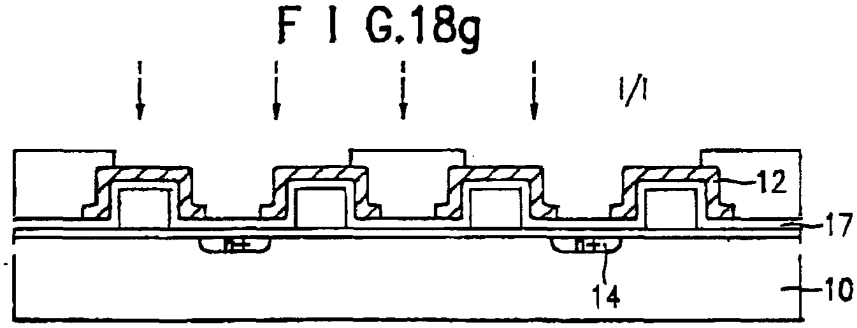


F I G.18h

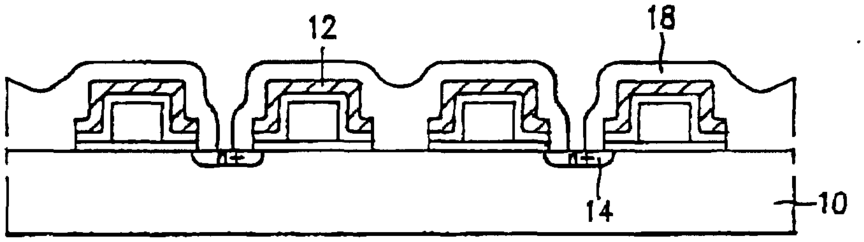


F I G.18i

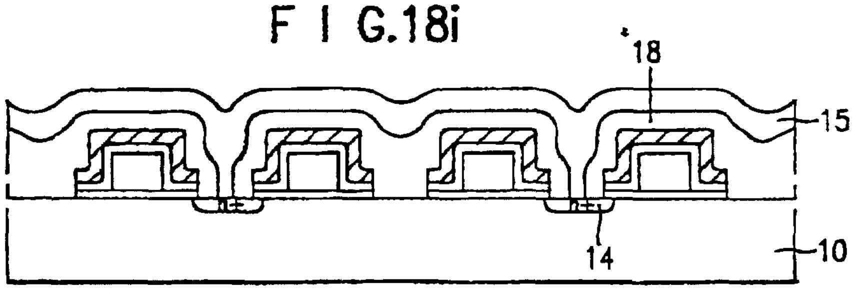

F I G.19

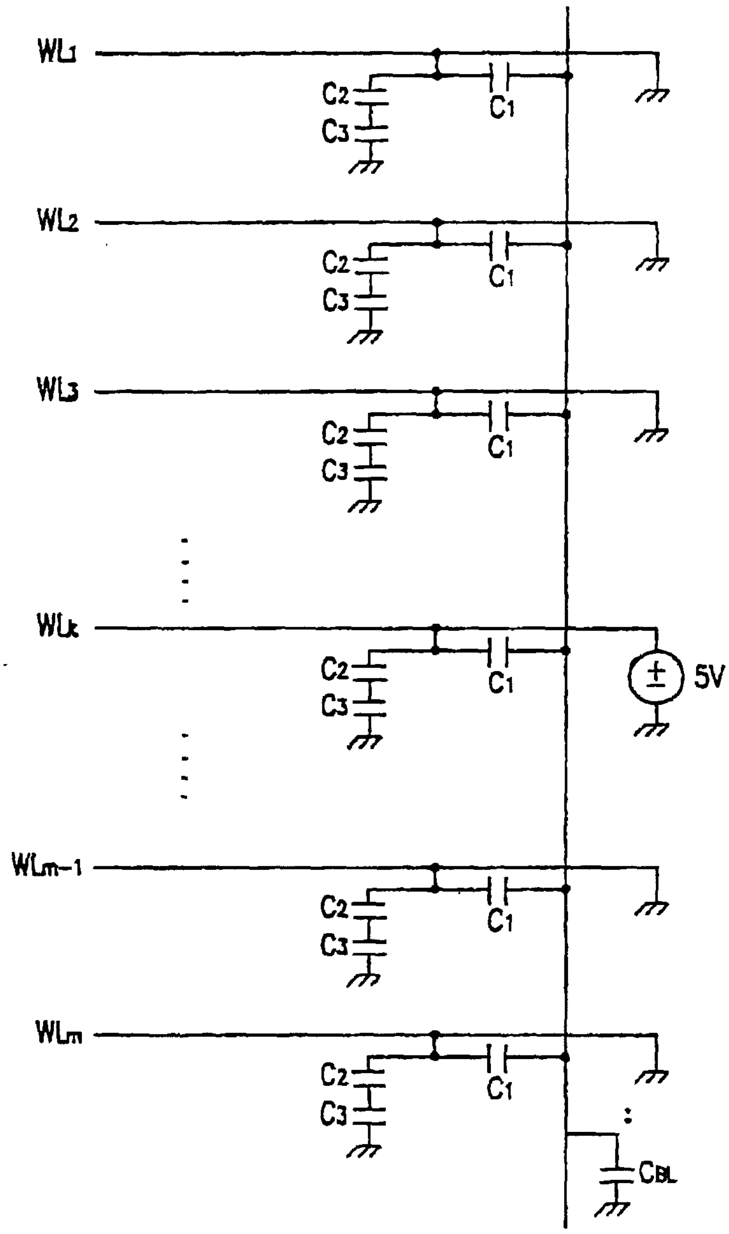
WL1
C2
C3
C1
WL2
C2
C3
C1
WL3
C2
C3
C1
WLk
C2
C3
C1
5V
WLm-1
C2
C3
C1
WLm
C2
C3
C1
CBL

F I G.20

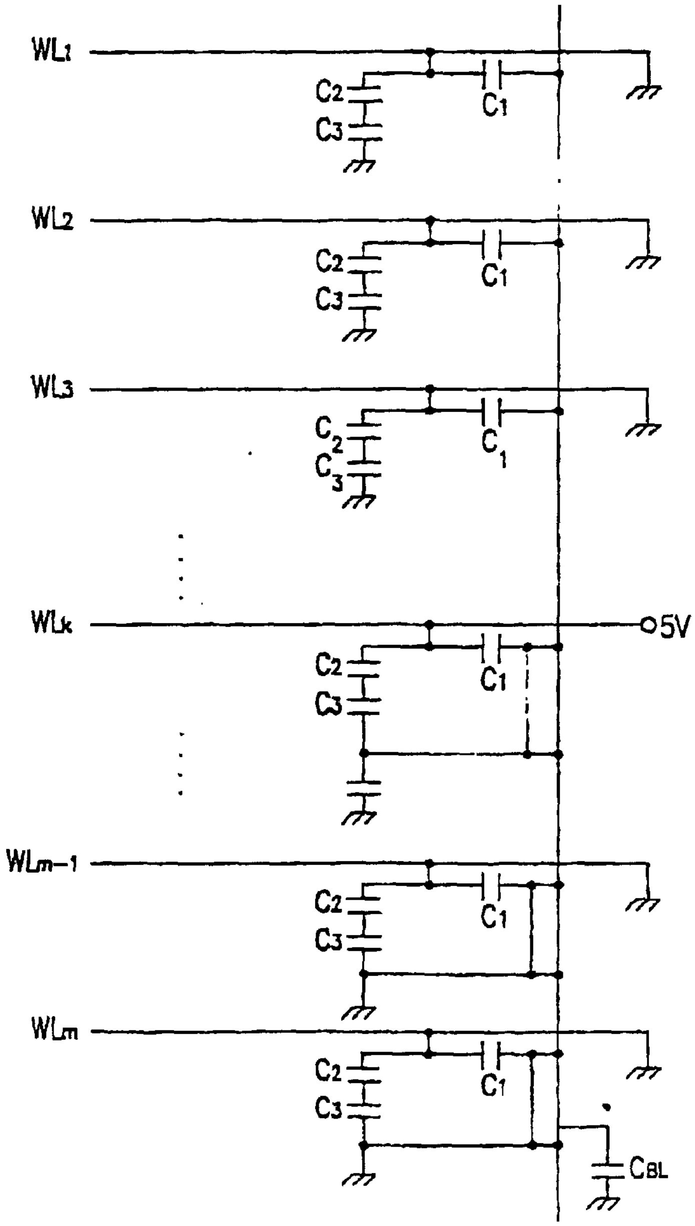
WL1
C2
C3
C1
WL2
C2
C3
C1
WL3
C2
C3
C1
WLk
5V
C2
C3
C1
WLm-1
C2
C3
C1
WLm
C2
C3
C1
CBL